# EUROPEAN PATENT APPLICATION

(11) **EP 3 199 275 A1**
(43) Date of publication of application: **02.08.2017**
(21) Application number: 15844105.5
(22) Date of filing: 18.09.2015
(51) Int. Cl.: B23B 27/14, C23C 16/34, C23C 16/36

(54) **SURFACE-COATED CUTTING TOOL IN WHICH HARD COATING LAYER EXHIBITS EXCELLENT CHIPPING RESISTANCE**

(30) Priority: 25.09.2014 JP 2014195080
(71) Applicant: Mitsubishi Materials Corporation, Chiyoda-ku Tokyo 100-8117 (JP)
(72) Inventor: TATSUOKA Sho, Naka-shi Ibaraki 311-0102 (JP); SATO Kenichi, Naka-shi Ibaraki 311-0102 (JP); YAMAGUCHI Kenji, Naka-shi Ibaraki 311-0102 (JP)
(74) Representative: Gille Hrabal
(86) International application number: PCT/JP2015/076654
(87) International publication number: WO 2016/047584

(57) **Abstract**

Provided is a coated tool in which a hard coating layer has excellent hardness and toughness and exhibits chipping resistance and defect resistance during long-term use. The hard coating layer includes at least a layer of a complex nitride or complex carbonitride expressed by the composition formula: (Ti_{1-x-y}AlₓMe_{y}) (C_{z}N_{1-z}) (here, Me is one element selected from among Si, Zr, B, V, and Cr), an average amount Xavg of Al, an average amount Yavg of Me, and an average amount Zavg of C satisfy 0.60 ≤ Xavg, 0.005 ≤ Yavg ≤ 0.10, 0 ≤ Zavg ≤ 0.005, and 0.605 ≤ Xavg + Yavg ≤ 0.95, crystal grains having a cubic structure are present in crystal grains constituting the layer of a complex nitride or complex carbonitride, and in the crystal grains having a cubic structure, a predetermined periodic composition variation of Ti, Al, and Me is present, whereby the problems are solved.

## Description

### Technical Field

The present invention relates to a surface-coated cutting tool (hereinafter, referred to as coated tool), in which a hard coating layer exhibits excellent chipping resistance during high-speed intermittent cutting work of alloy steel or the like during which high-temperature heat is generated and an impact load is exerted on a cutting edge, and excellent cutting performance is exhibited during long-term use.

### Background Art

Hitherto, in general, coated tools in which the surfaces of bodies made of tungsten carbide (hereinafter, referred to as WC)-based cemented carbide, titanium carbonitride (hereinafter, referred to as TiCN)-based cermet, or a cubic boron nitride (hereinafter, referred to as cBN)-based ultrahigh-pressure sintered body (hereinafter, collectively referred to as a body) are coated with a Ti-Al-based complex nitride layer as a hard coating layer through a physical vapor deposition method are known, and it is known that these coated tools exhibit excellent wear resistance.

However, although the coated tool coated with the Ti-Al-based complex nitride layer in the related art has relatively excellent wear resistance, in a case of using the coated tool under high-speed intermittent cutting conditions, abnormal wear such as chipping easily occurs. Therefore, various suggestions for an improvement in the hard coating layer have been made.

For example, PTL 1 suggests that the heat resistance and fatigue strength of a coated tool are improved by coating the outside of a TiCN layer and an Al₂O₃ layer as inner layers with a (Ti₁₋ₓAlₓ)N layer (here, x is 0.65 to 0.9) having a cubic crystal structure or a cubic crystal structure including a hexagonal crystal structure as an outer layer using a chemical vapor deposition method, and applying a compressive stress of 100 MPa to 1100 MPa to the outer layer.

In addition, PTL 2 discloses a surface-coated cutting tool including a tool body and a hard coating layer formed on the body, in which the hard coating layer contains a compound including one or both of the elements Al and Cr, at least one element selected from the group consisting of the elements in Groups 4a, 5a, and 6a in the periodic table and Si, and at least one element selected from the group consisting of carbon, nitrogen, oxygen, and boron, and chlorine, thereby dramatically improving the wear resistance and oxidation resistance of the hard coating layer.

In addition, PTL 3 describes that by performing chemical vapor deposition in a mixed reaction gas of TiCl₄, AlCl₃, and NH₃ in a temperature range of 650°C to 900°C, a (Ti₁₋ₓAlₓ)N layer in which the value of the amount x of Al is 0.65 to 0.95 can be deposited. However, this literature is aimed at further coating the (Ti₁₋ₓAlₓ)N layer with an Al₂O₃ layer and thus improving a heat insulation effect. Therefore, there is no disclosure of the effect of the formation of the (Ti₁₋ₓAlₓ)N layer in which the value of x is increased to 0.65 to 0.95 on cutting performance.

### Citation List

### Patent Literature

- [PTL 1]: JP-T-2011-513594
- [PTL 2]: JP-A-2006-82207
- [PTL 3]: JP-T-2011-516722

### Summary of Invention

### Technical Problem

There has been a strong demand for power saving and energy saving during cutting work in recent years. In accordance with this, there is a trend toward a further increase in speed and efficiency during cutting work. Therefore, abnormal damage resistance such as chipping resistance, defect resistance, and peeling resistance is further required for a coated tool, and excellent wear resistance is required during long-term use.

However, although the coated tool described in PTL 1 has a predetermined hardness and excellent wear resistance, the toughness thereof is deteriorated. Therefore, in a case where the coated tool is provided for high-speed intermittent cutting work of alloy steel or the like, there are problems in that abnormal damage such as chipping, defects, and peeling easily occurs and it cannot be said that satisfactory cutting performance is exhibited.

In addition, although the coated tool described in PTL 2 is intended to improve the wear resistance and oxidation resistance, there is a problem in that the chipping resistance is insufficient under cutting conditions of high-speed intermittent cutting or the like accompanied with impacts.

On the other hand, in the (Ti₁₋ₓAlₓ)N layer deposited through the chemical vapor deposition method described in PTL 3, the amount x of Al can be increased, and due to the formation of the cubic crystal structure, a hard coating layer having a predetermined hardness and excellent wear resistance is obtained. However, there are problems in that the adhesion strength thereof to a body is insufficient and the toughness thereof may be deteriorated.

Here, a technical problem to be solved by the present invention, that is, an object of the present invention is to provide a coated tool which has excellent toughness and exhibits excellent chipping resistance and wear resistance during long-term use even in a case of being provided for high-speed intermittent cutting of alloy steel, carbon steel, cast iron, or the like. Solution to Problem

Therefore, from the above-described viewpoints, the inventors intensively studied to improve the chipping resistance and wear resistance of a coated tool in which a hard coating layer containing at least a complex nitride or complex carbonitride of Ti and Al (hereinafter, sometimes referred to as "(Ti,Al)(C,N)" or "(Ti₁₋ₓAlₓ)(C_{y}N_{1-y})") is deposited through chemical vapor deposition. As a result, the following knowledge was obtained.

That is, in the related art, in a hard coating layer which includes at least one (Ti₁₋ₓAlₓ)(C_{y}N_{1-y}) layer and has a predetermined average layer thickness, in a case where the (Ti₁₋ₓAlₓ)(C_{y}N_{1-y}) layer is formed in a columnar shape in a direction perpendicular to a tool body, the hard coating layer has high wear resistance. On the other hand, as the anisotropy of the (Ti₁₋ₓAlₓ)(C_{y}N_{1-y}) layer increases, the toughness of the (Ti₁₋ₓAlₓ)(C_{y}N_{1-y}) layer decreases. As a result, the chipping resistance and defect resistance thereof decrease, and wear resistance is insufficiently exhibited during long-term use. In addition, it cannot be said that the service life of the tool is satisfactory.

The inventors intensively studied a (Ti₁₋ₓAlₓ)(C_{y}N_{1-y}) layer included in a hard coating layer, and on the basis of a completely novel idea that a (Ti_{1-x-y}AlₓMe_{y})(C_{z}N_{1-z}) layer is constituted by crystal grains mainly having an NaCl type face-centered cubic structure by causing one element selected from among Si, Zr, B, V, and Cr (hereinafter, referred to as "Me") to be included in the hard coating layer and and a periodic concentration variation of Ti, Al, and Me is formed in the cubic crystal phase, succeeded in introducing strain into the cubic crystal grains and increasing hardness and toughness. As a result, novel knowledge that the chipping resistance and defect resistance of the hard coating layer can be improved was discovered.

Specifically, it was found that a hard coating layer includes at least a layer of a complex nitride or complex carbonitride of Ti, Al, and Me (here, Me is one element selected from among Si, Zr, B, V, and Cr), the layer being formed to an average layer thickness of 1 µm to 20 µm in a chemical vapor deposition method, in a case where the layer is expressed by the composition formula: (Ti_{1-x-y}AlₓMe_{y})(C_{z}N_{1-z}), an average amount Xavg of Al in a total amount of Ti, Al, and Me, an average amount Yavg of Me in the total amount of Ti, Al, and Me, and an average amount Zavg of C in a total amount of C and N (here, each of Xavg, Yavg, and Zavg is in atomic ratio) satisfy 0.60 ≤ Xavg, 0.005 ≤ Yavg ≤ 0.10, 0 ≤ Zavg ≤ 0.005, and 0.605 ≤ Xavg + Yavg ≤ 0.95, the layer of a complex nitride or complex carbonitride includes crystal grains having an NaCl type face-centered cubic structure (or further includes crystal grains having a wurtzite type hexagonal structure), in a case where crystal orientations of crystal grains of the complex nitride or complex carbonitride of Ti, Al, and Me having a NaCl type face-centered cubic structure in the layer of a complex nitride or complex carbonitride are analyzed in a longitudinal sectional direction using an electron backscatter diffraction apparatus, when an inclined angle frequency distribution is obtained by measuring inclined angles of normal lines of {100} planes which are crystal planes of the crystal grains with respect to a normal direction of the surface of the tool body, dividing inclined angles in a range of 0 degrees to 45 degrees with respect to the normal direction among the inclined angles into intervals of 0.25 degrees, and aggregating frequencies present in the respective divisions, a highest peak is present in an inclined angle division in a range of 0 degrees to 12 degrees, and a sum of frequencies that are present in the range of 0 degrees to 12 degrees has a proportion of 35% or more in a total of the frequencies in the inclined angle frequency distribution, in the crystal grains having an NaCl type face-centered cubic structure, a periodic concentration variation of Ti, Al, and Me in the composition formula: (Ti_{1-x-y}AlₓMe_{y})(C_{z}N_{1-z}) is present (that is, x, y, and z are not constant values but periodically varying values), in a case where an average value of local maximum of values of periodically varying x of an amount x of Al is referred to as Xmax and an average value of local minimum of the values of periodically varying x of the amount x of Al is referred to as Xmin, a difference Δx between Xmax and Xmin is 0.03 to 0.25, in the crystal grains having an NaCl type face-centered cubic structure in which the periodic concentration variation of Ti, Al, and Me is present in the layer of a complex nitride or complex carbonitride, a period along the normal direction of the surface of the tool body is 3 nm to 100 nm, whereby strain is introduced into the crystal grains having an NaCl type face-centered cubic structure, the hardness and toughness of the (Ti_{1-x-y}AlₓMe_{y})(C_{z}N_{1-z}) layer are increased compared to a hard coating layer in the related art, chipping resistance and defect resistance are correspondingly improved, and excellent wear resistance is exhibited during long-term use.

In addition, the (Ti_{1-x-y}AlₓMe_{y})(C_{z}N_{1-z}) layer having the configuration described above can be formed by, for example, the following chemical vapor deposition method in which the composition of a reaction gas varies periodically on the surface of the tool body.

In a chemical vapor deposition reaction apparatus which is used, a gas group A of NH₃, N₂, and H₂ and a gas group B of TiCl₄, Al(CH₃)₃, AlCl₃, MeClₙ (chloride of Me), NH₃, N₂, and H₂ are supplied into the reaction apparatus from separate gas supply tubes, the supplying of the gas group A and the gas group B into the reaction apparatus is performed so that, for example, the gases are allowed to flow at time intervals of a predetermined period only for a shorter time than the period, the supplying of the gases of the gas group A and the gas group B has a phase difference of a time shorter than the time for which the gases are supplied, and the composition of the reaction gas on the surface of the tool body can be changed over time between (a) the gas group A, (b) a mixed gas of the gas group A and the gas group B, and (c) the gas group B. Moreover, in the present invention, there is no need to introduce a long-term exhaust process intended for strict gas substitution. Therefore, as a gas supply method, for example, it is possible to realize the composition of the reaction gas on the surface of the tool body being able to be changed over time between (a) a mixed gas primarily containing the gas group A, (b) a mixed gas of the gas group A and the gas group B, and (c) a mixed gas primarily containing the gas group B by rotating gas supply ports, rotating the tool body, or reciprocating the tool body.

The (Ti_{1-x-y}AlₓMe_{y})(C_{z}N_{1-z}) layer having a predetermined target layer thickness is formed on the surface of the tool body by performing a thermal CVD method for a predetermined time, for example, using, as the composition of the reaction gas (% by volume with respect to the total amount of the gas group A and the gas group B), the gas group A of NH₃: 3.5% to 4.0%, N₂: 0% to 5%, and H₂: 55% to 60% and the gas group B of AlCl₃: 0.6% to 0.9%, TiCl₄: 0.2% to 0.3%, MeClₙ (chloride of Me): 0.1% to 0.2%, Al(CH₃)₃: 0% to 0.5%, N₂: 0.0% to 12.0%, and H₂: the remainder, under a reaction atmosphere pressure of 4.5 kPa to 5.0 kPa, at a reaction atmosphere temperature of 700°C to 900°C, and with a supply period of 1 second to 5 seconds, a gas supply time of 0.15 seconds to 0.25 seconds per one period, and a phase difference between gas supply A and gas supply B of 0.10 seconds to 0.20 seconds.

As described above, the gas group A and the gas group B are supplied so that the times at which the gas group A and the gas group B arrive at the surface of the tool body are different from each other, a nitrogen raw material gas in the gas group A is set to NH₃: 3.5% to 4.0% and N₂: 0% to 5%, and a metal chloride raw material or a carbon raw material in the gas group B is set to AlCl₃: 0.6% to 0.9%, TiCl₄: 0.2% to 0.3%, MeClₙ (chloride of Me): 0.1% to 0.2%, or Al(CH₃)₃: 0% to 0.5%. Accordingly, local compositional unevenness, dislocations, and point defects are introduced into crystal grains, such that local strain in a crystal lattice is formed. Furthermore, the degree of {100} orientation on the surface side of the tool body and on the surface side of the coating in the crystal grains can be changed. As a result, it was found that toughness is dramatically improved while wear resistance is maintained. As a result, particularly defect resistance and chipping resistance are improved. Therefore, it was found that even in a case where the coated body is used for high-speed intermittent cutting work of alloy steel or the like during which intermittent and impact loads are exerted on a cutting edge, the hard coating layer can exhibit excellent cutting performance during long-term use.

The present invention is made based on the above-described knowledge and is characterized by including
"(1) a surface-coated cutting tool in which a hard coating layer is provided on a surface of a tool body made of any of tungsten carbide-based cemented carbide, titanium carbonitride-based cermet, and a cubic boron nitride-based ultrahigh-pressure sintered body, in which
   (a) the hard coating layer includes at least a layer of a complex nitride or complex carbonitride of Ti, Al, and Me (here, Me is one element selected from among Si, Zr, B, V, and Cr), the layer being formed to an average layer thickness of 1 µm to 20 µm in a chemical vapor deposition method, and in a case where the layer is expressed by the composition formula: (Ti_{1-x-y}AlₓMe_{y})(C_{z}N_{1-z}), an average amount Xavg of Al of the layer of a complex nitride or complex carbonitride in a total amount of Ti, Al, and Me, an average amount Yavg of Me in the total amount of Ti, Al, and Me, and an average amount Zavg of C in a total amount of C and N (here, each of Xavg, Yavg, and Zavg is in atomic ratio) satisfy 0.60 ≤ Xavg, 0.005 ≤ Yavg ≤ 0.10, 0 ≤ Zavg ≤ 0.005, and 0.605 ≤ Xavg + Yavg ≤ 0.95,
   (b) the layer of a complex nitride or complex carbonitride includes at least a phase of a complex nitride or complex carbonitride of Ti, Al, and Me having an NaCl type face-centered cubic structure,
   (c) in a case where crystal orientations of crystal grains of the complex nitride or complex carbonitride of Ti, Al, and Me having an NaCl type face-centered cubic structure in the layer of a complex nitride or complex carbonitride are analyzed in a longitudinal sectional direction using an electron backscatter diffraction apparatus, when an inclined angle frequency distribution is obtained by measuring inclined angles of normal lines of {100} planes which are crystal planes of the crystal grains with respect to a normal direction of the surface of the tool body, dividing inclined angles in a range of 0 degrees to 45 degrees with respect to the normal direction among the inclined angles into intervals of 0.25 degrees, and aggregating frequencies present in the respective divisions, a highest peak is present in an inclined angle division in a range of 0 degrees to 12 degrees, and a sum of frequencies that are present in the range of 0 degrees to 12 degrees has a proportion of 35% or more in a total of the frequencies in the inclined angle frequency distribution,
   (d) in the crystal grains of the complex nitride or complex carbonitride of Ti, Al, and Me having an NaCl type face-centered cubic structure, a periodic concentration variation of Ti, Al, and Me in the composition formula: (Ti_{1-x-y}AlₓMe_{y})(C_{z}N_{1-z}) is present, and in a case where an average value of local maximum of values of periodically varying x of an amount x of Al is referred to as Xmax and an average value of local minimum of the values of periodically varying x of the amount x of Al is referred to as Xmin, a difference Δx between Xmax and Xmin is 0.03 to 0.25, and
   (e) in the crystal grains having an NaCl type face-centered cubic structure in which the periodic concentration variation of Ti, Al, and Me is present in the layer of a complex nitride or complex carbonitride, a period along the normal direction of the surface of the tool body is 3 nm to 100 nm.
(2) The surface-coated cutting tool described in (1), in which, in the crystal grains having an NaCl type face-centered cubic structure in which the periodic concentration variation of Ti, Al, and Me is present in the layer of a complex nitride or complex carbonitride, the periodic concentration variation of Ti, Al, and Me is present along one orientation among equivalent crystal orientations expressed by <001> of the cubic crystal grains, a period along the orientation is 3 nm to 100 nm, and an maximum ΔXo of a change in the amount x of Al in a plane perpendicular to the orientation is 0.01 or less.
(3) The surface-coated cutting tool described in (1), in which, in the crystal grains having an NaCl type face-centered cubic structure in which the periodic concentration variation of Ti, Al, and Me is present in the layer of a complex nitride or complex carbonitride,
   (a) an area in which the periodic concentration variation of Ti, Al, and Me is present along one orientation among equivalent crystal orientations expressed by <001> of the cubic crystal grains, and when the orientation is referred to as an orientation d_{A}, a period along the orientation d_{A} is 3 nm to 100 nm and an maximum ΔXod_{A} of a change in the amount x of Al in a plane perpendicular to the orientation d_{A} is 0.01 or less is provided, and
   (b) an area in which the periodic concentration variation of Ti, Al, and Me is present along one orientation among equivalent crystal orientations expressed by <001> of the cubic crystal grains perpendicular to the orientation d_{A}, and when the orientation is referred to as an orientation d_{B}, a period along the orientation d_{B} is 3 nm to 100 nm and an maximum ΔXod_{B} of a change in the amount x of Al in a plane perpendicular to the orientation d_{B} is 0.01 or less is provided,
      the area A and the area B are present in the crystal grains, and
      a boundary between the area A and the area B is formed in one plane among equivalent crystal planes expressed by {110}.
(4) The surface-coated cutting tool described in any one of (1) to (3), in which, regarding the layer of a complex nitride or complex carbonitride, lattice constants a of the crystal grains having an NaCl type face-centered cubic structure are obtained from X-ray diffraction, and the lattice constants a of the crystal grains having an NaCl type face-centered cubic structure satisfy a relationship of 0.05a_{TiN} + 0.95a_{AlN} ≤ a ≤ 0.4a_{TiN} + 0.6a_{AlN} for a lattice constant a_{TiN} of cubic TiN and a lattice constant a_{AlN} of cubic AlN.
(5) The surface-coated cutting tool described in any one of (1) to (4), in which, regarding the layer of a complex nitride or complex carbonitride, in a case where the layer is observed in the longitudinal sectional direction, a columnar structure in which the crystal grains of the complex nitride or complex carbonitride of Ti, Al, and Me having an NaCl type face-centered cubic structure in the layer have an average grain width W of 0.1 µm to 2.0 µm and an average aspect ratio A of 2 to 10 is included.
(6) The surface-coated cutting tool described in any one of (1) to (5), in which, in the layer of a complex nitride or complex carbonitride, an area ratio of the complex nitride or complex carbonitride of Ti, Al, and Me having an NaCl type face-centered cubic structure is 70% by area or more.
(7) The surface-coated cutting tool described in any one of (1) to (6), in which between the tool body made of any of tungsten carbide-based cemented carbide, titanium carbonitride-based cermet, and a cubic boron nitride-based ultrahigh-pressure sintered body, and the layer of a complex nitride or complex carbonitride of Ti, Al, and Me, a lower layer which includes a Ti compound layer that is formed of one layer or two or more layers of a Ti carbide layer, a Ti nitride layer, a Ti carbonitride layer, a Ti oxycarbide layer, and a Ti oxycarbonitride layer and has an average total layer thickness of 0.1 µm to 20 µm is present.
(8) The surface-coated cutting tool described in any one of (1) to (7), in which an upper layer which includes an aluminum oxide layer having an average layer thickness of at least 1 µm to 25 µm is present in an upper portion of the layer of a complex nitride or complex carbonitride.
(9) The surface-coated cutting tool described in any one of (1) to (8), in which the layer of a complex nitride or complex carbonitride is formed by a chemical vapor deposition method in which at least trimethylaluminum is contained as a reaction gas component."

Although the hard coating layer in the present invention has the layer of a complex nitride or complex carbonitride described above as its essential configuration, it is needless to say that by using the lower layer described in (7), the upper layer described in (8), and the like, which are hitherto well known, in combination, better characteristics can be created in combination with the effects of the layer of a complex nitride or complex carbonitride.

The present invention will be described below in detail.

Average Layer Thickness of Layer of Complex Nitride or Complex Carbonitride Included in Hard Coating Layer:

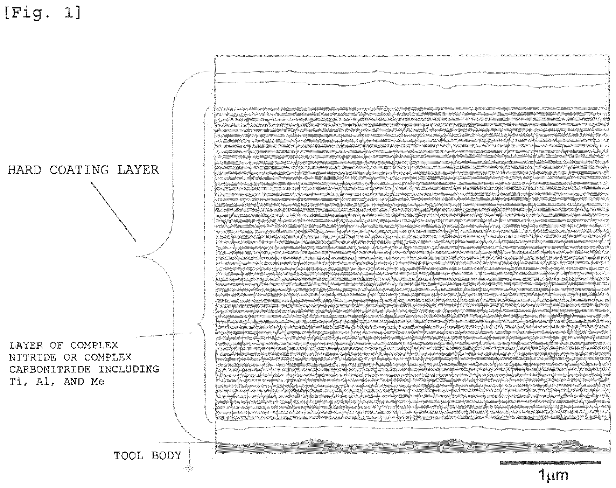

Fig. 1 is a schematic sectional view of the layer of a complex nitride or complex carbonitride of Ti, Al, and Me included in the hard coating layer of the present invention.

The hard coating layer of the present invention includes at least the layer of a complex nitride or complex carbonitride of Ti, Al, and Me which is formed through chemical vapor deposition and is expressed by the composition formula: (Ti_{1-x-y}AlₓMe_{y})(C_{z}N_{1-z}). The layer of a complex nitride or complex carbonitride has high hardness and excellent wear resistance, and the effect thereof is significantly exhibited particularly when the average layer thickness thereof is 1 µm to 20 µm. The reason for this is that when the average layer thickness thereof is smaller than 1 µm, the layer thickness thereof is too small to sufficiently ensure wear resistance during long-term use, and when the average layer thickness thereof is greater than 20 µm, the crystal grains of the layer of a complex nitride or complex carbonitride of Ti, Al, and Me are likely to coarsen and chipping easily occurs. Therefore, the average layer thickness thereof is determined to be 1 µm to 20 µm.

Composition of Layer of Complex Nitride or Complex Carbonitride Included in Hard Coating Layer:
The layer of a complex nitride or complex carbonitride included in the hard coating layer of the present invention is controlled such that in a case where the layer is expressed by the composition formula: (Ti_{1-x-y}AlₓMe_{y})(C_{z}N_{1-z}) (here, Me is one element selected from among Si, Zr, B, V, and Cr), the average amount Xavg of Al in the total amount of Ti, Al, and Me, the average amount Yavg of Me in the total amount of Ti, Al, and Me, and the average amount Zavg of C in the total amount of C and N (here, each of Xavg, Yavg, and Zavg is in atomic ratio) satisfy 0.60 ≤ Xavg, 0.005 ≤ Yavg ≤ 0.10, 0 ≤ Zavg ≤ 0.005, and 0.605 ≤ Xavg + Yavg ≤ 0.95.

The reason for this is that when the average amount Xavg of Al is less than 0.60, the hardness of the layer of a complex nitride or complex carbonitride of Ti, Al, and Me deteriorates. Therefore, in a case where the layer is provided for high-speed intermittent cutting of alloy steel or the like, the wear resistance thereof is insufficient. In addition, when the average amount Yavg of Me is less than 0.005, the hardness of the layer of a complex nitride or complex carbonitride of Ti, Al, and Me deteriorates. Therefore, in a case where the layer is provided for high-speed intermittent cutting of alloy steel or the like, the wear resistance thereof is insufficient. On the other hand, when the average amount thereof is more than 0.10, the toughness of the layer of a complex nitride or complex carbonitride of Ti, Al, and Me decreases due to segregation or the like of Me to grain boundaries. Therefore, in a case where the layer is provided for high-speed intermittent cutting of alloy steel or the like, the chipping resistance thereof is insufficient. Therefore, the average amount Yavg of Me was determined to be 0.005 ≤ Yavg ≤ 0.10.

On the other hand, when the sum Xavg + Yavg of the average amount Xavg of Al and the average amount Yavg of Me is less than 0.605, the hardness of the layer of a complex nitride or complex carbonitride of Ti, Al, and Me deteriorates. Therefore, in a case where the layer is provided for high-speed intermittent cutting of alloy steel or the like, the wear resistance thereof is insufficient. When the sum is more than 0.95, the amount of Ti is relatively reduced, resulting in embrittlement and a reduction in chipping resistance. Therefore, the sum Xavg + Yavg of the average amount Xavg of Al and the average amount Yavg of Me is determined to be 0.605 ≤ Xavg + Yavg ≤0.95.

Here, as the specific component of Me, one element selected from among Si, Zr, B, V, and Cr is used.

In a case where the component Si or B is used as Me so as to cause Yavg to be 0.005 or more, the hardness of the layer of a complex nitride or complex carbonitride is improved, resulting in an improvement in wear resistance. The component Zr has an action of strengthening crystal grain boundaries. In addition, the component V improves toughness and thus achieves a further improvement in chipping resistance. The component Cr improves oxidation resistance such that a further increase in the tool life is expected. However, when the average amount Yavg of any of the components is more than 0.10, the average amount of the component Al or Ti is relatively reduced, resulting in a trend toward a reduction in wear resistance or chipping resistance. Therefore, an average amount Yavg of more than 0.10 has to be avoided.

In addition, when the average amount (atomic ratio) Zavg of C contained in the layer of a complex nitride or complex carbonitride is a small amount in a range of 0 ≤ Zavg ≤ 0.005, the adhesion between the layer of a complex nitride or complex carbonitride and the tool body or the lower layer is improved. In addition, the lubricity thereof is improved and thus an impact during cutting is relieved, resulting in an improvement in the defect resistance and chipping resistance of the layer of a complex nitride or complex carbonitride. On the other hand, when the average amount Zavg of C is outside of the range of 0 ≤ Zavg ≤ 0.005, the toughness of the layer of a complex nitride or complex carbonitride decreases. Therefore, the defect resistance and chipping resistance, in contrast, decrease, which is not preferable. Therefore, the average amount Zavg of C is determined to be 0 ≤ Zavg ≤ 0.005.

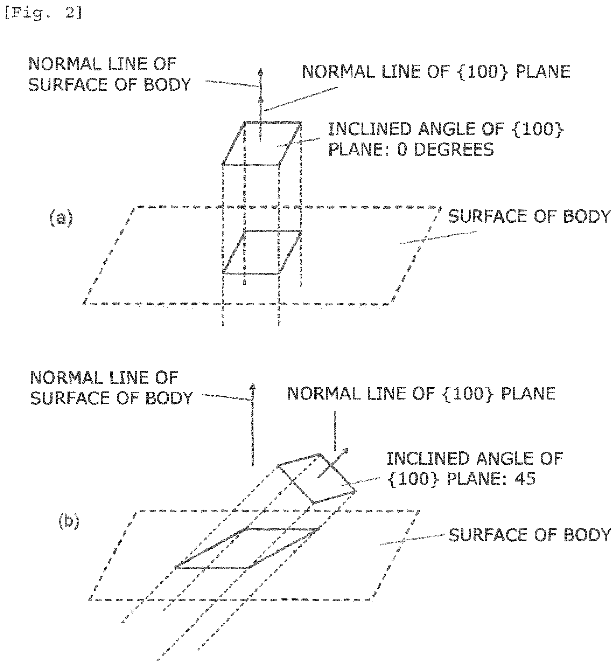

Inclined Angle Frequency Distribution for {100} Planes as Crystal Planes of Individual Crystal grains Having NaCl Type Face-Centered Cubic Structure in Layer of Complex Nitride or Complex Carbonitride of Ti, Al, and Me ((Ti_{1-x-y}AlₓMe_{y})(C_{z}N_{1-z}) Layer) :
Regarding the (Ti_{1-x-y}AlₓMe_{y})(C_{z}N_{1-z}) layer of the present invention, in a case where the crystal orientations of individual crystal grains having an NaCl type face-centered cubic structure are analyzed in the longitudinal sectional direction thereof using an electron backscatter diffraction apparatus, the inclined angles (see Figs. 2(a) and 2(b)) of normal lines of {100} planes which are the crystal planes of the crystal grains with respect to the normal line of the surface of the tool body (a direction perpendicular to the surface of the tool body in a polished section) are measured. When inclined angles in a range of 0 degrees to 45 degrees with respect to the normal direction among the measured inclined angles are divided into intervals of 0.25 degrees and frequencies in the respective divisions are aggregated, in a case where a form of an inclined angle frequency distribution is shown in which a highest peak is present in an inclined angle division in a range of 0 degrees to 12 degrees and the sum of frequencies that are present in the range of 0 degrees to 12 degrees has a proportion of 35% or more in the total of the frequencies in the inclined angle frequency distribution, the hard coating layer including the layer of a complex nitride or complex carbonitride of Ti, Al, and Me has high hardness while maintaining the NaCl type face-centered cubic structure. Furthermore, with the form of the inclined angle frequency distribution as described above, the adhesion between the hard coating layer and the body is dramatically improved.

Therefore, even in a case where the coated tool is used, for example, for high-speed intermittent cutting of alloy steel or the like, the occurrence of chipping, defects, peeling, and the like is suppressed, and furthermore, excellent wear resistance is exhibited.

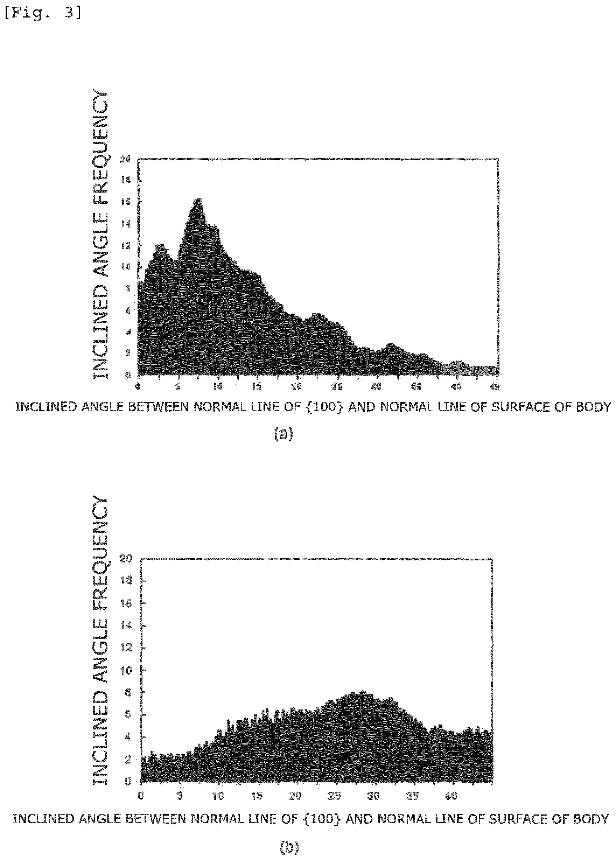

Figs. 3(a) and 3(b) show graphs of an example of inclined angle frequency distributions obtained by measuring crystal grains having a cubic structure of an embodiment of the present invention and crystal grains having a comparative cubic structure in the above-described method,

Crystal grains Having NaCl Type Face-Centered Cubic Structure (hereinafter, simply referred to as "cubic") Included in Layer of Complex Nitride or Complex Carbonitride:
In a case where each cubic crystal grain in the layer of a complex nitride or complex carbonitride is observed and measured from the coating film section side which is perpendicular to the surface of the tool body, in a case where the grain width thereof in a direction parallel to the surface of the tool body is referred to as w, the grain length thereof in the direction perpendicular to the surface of the tool body is referred to as l, the ratio l/w between w and l is referred to as the aspect ratio a of each crystal grain, the average value of the aspect ratios a obtained for the individual crystal grains is further referred to as an average aspect ratio A, and the average value of the grain widths w obtained for the individual crystal grains is referred to as an average grain width W, it is preferable that the average grain width W and the average aspect ratio A are controlled to satisfy 0.1 µm to 2.0 µm and 2 to 10, respectively.

When this condition is satisfied, the cubic crystal grains constituting the layer of a complex nitride or complex carbonitride have a columnar structure and exhibit excellent wear resistance. On the other hand, when the average aspect ratio A is lower than 2, a periodic composition distribution, which is a feature of the present invention, is less likely to be formed in the crystal grains having an NaCl type face-centered cubic structure. When a columnar crystal has an average aspect ratio A of higher than 10, cracks are likely to propagate on a plane along a periodic composition distribution in a cubic crystal phase, which is a feature of the present invention, and along a plurality of grain boundaries, which is not preferable. In addition, when the average grain width W is smaller than 0.1 µm, wear resistance decreases. When the average grain width W is greater than 2.0 µm, toughness decreases. Therefore, the average crystal grain width W of the cubic crystal grains constituting the layer of a complex nitride or complex carbonitride is desirably 0.1 µm to 2.0 µm.

Concentration variation of Ti, Al, and Me Present in Crystal grains Having Cubic Crystal Structure:

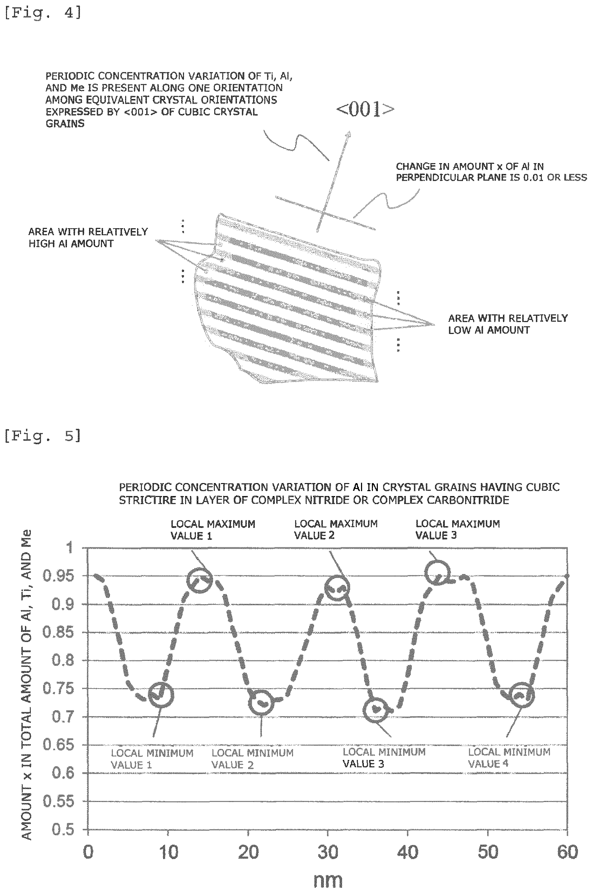

Fig. 4 shows that regarding the crystal grains having a cubic crystal structure in the layer of a complex nitride or the layer of a complex carbonitride of Ti, Al, and Me of the present invention, a periodic concentration variation of Ti, Al, and Me is present along one orientation among equivalent crystal orientations expressed by <001> of the cubic crystal grains, and a change in the amount x of Al in a plane perpendicular to the orientation is small, as a schematic view.

In addition, Fig. 5 shows an example of a graph of the periodic concentration variation x of Al with respect to the sum of Ti, Al, and Me as a result of line analysis performed by energy-dispersive X-ray spectroscopy (EDS) using a transmission electron microscope on the crystal grains having a cubic crystal structure in which the periodic concentration variation of Ti, Al, and Me is present in the section of the layer of a complex nitride or the layer of a complex carbonitride of Ti, Al, and Me of the present invention.

In a case where crystals having a cubic crystal structure are expressed by the composition formula: (Ti_{1-x-y}AlₓSi_{y})(C_{z}N_{1-z}), when a periodic concentration variation of Ti, Al, and Me is present in crystal grains (that is, when x, y, and z are not constant values but periodically varying values), strain occurs in the crystal grains, resulting in an improvement in hardness. In a case where the average value of local maximum of values of periodically varying x of the amount x of Al in the composition formula, which is an index of the degree of the concentration variation of Ti, Al, and Me is referred to as Xmax and the average value of local minimum of the values of periodically varying x of the amount x of Al is referred to as Xmin, when the difference Δx between Xmax and Xmin is smaller than 0.03, the degree of strain in the crystal grains described above is low, and a sufficient improvement in hardness cannot be expected. On the other hand, when the difference Δx between Xmax and Xmin is greater than 0.25, the degree of strain in the crystal grains becomes too high, there are more lattice defects, and hardness decreases. Here, regarding the concentration variation of Ti, Al, and Me present in the crystal grains having a cubic crystal structure, the difference between Xmax and Xmin was set to 0.03 to 0.25.

In the crystal grains having a cubic crystal structure in which the periodic concentration variation of Ti, Al, and Me is present in the layer of a complex nitride or complex carbonitride, in a case where the periodic concentration variation of Ti, Al, and Me is present along one orientation among equivalent crystal orientations expressed by <001> of the cubic crystal grains, lattice defects due to the strain of the crystal grains are less likely to be generated, resulting in an improvement in toughness.

In addition, the concentration of Ti, Al, and Me in the plane perpendicular to the orientation in which the periodic concentration variation of Ti, Al, and Me described above is present does not substantially vary, and the maximum ΔXo of the change in the amount x of Al in the total amount of Ti, Al, and Me in the perpendicular plane is 0.01 or smaller.

In addition, when the period of the concentration variation along one orientation among the equivalent crystal orientations expressed by <001> of the cubic crystal grains is smaller than 3 nm, the toughness decreases. When the period is greater than 100 nm, the effect of improving hardness cannot be sufficiently exhibited. Therefore, a more preferable period of the concentration variation is 3 nm to 100 nm.

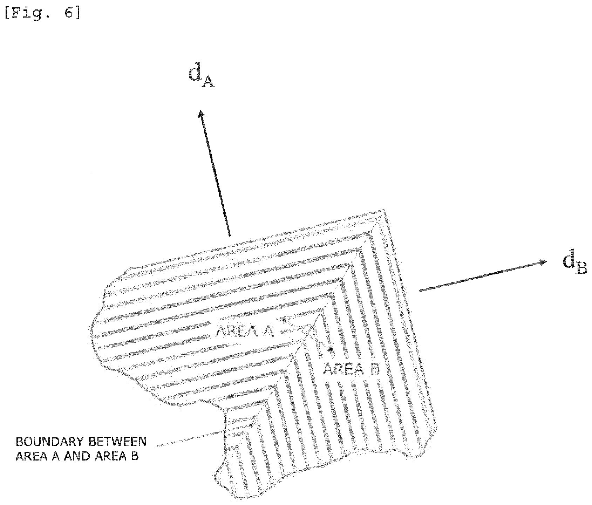

Fig. 6 shows that an area A and an area B are present in the crystal grains regarding the crystal grains having a cubic crystal structure in which the periodic concentration variation of Ti, Al, and Me is present in the section of the layer of a complex nitride or the layer of a complex carbonitride of Ti, Al, and Me of the present invention, as a schematic view.

Regarding the crystal grains in which the area A and the area B in which the periodic concentration variation of Ti, Al, and Me is present in two directions perpendicular to each other are present in the crystal grains, strain is present in the two directions in the crystal grains, resulting in an improvement in toughness. Furthermore, as the boundary between the area A and the area B is formed in one plane among equivalent crystal planes expressed by {110}, misfits at the boundary between the area A and the area B do not occur, and thus high toughness can be maintained.

That is, in a case where the area A in which, in a case where the periodic concentration variation of Ti, Al, and Me is present along one orientation among the equivalent crystal orientations expressed by <001> of the cubic crystal grains and the orientation is referred to as an orientation d_{A}, the period along the orientation d_{A} is 3 nm to 100 nm and the maximum ΔXod_{A} of a change in the amount x of Al in a plane perpendicular to the orientation d_{A} is 0.01 or less, and the area B in which, in a case where the periodic concentration variation of Ti, Al, and Me is present along one orientation among equivalent crystal orientations expressed by <001> of the cubic crystal grains perpendicular to the orientation d_{A} and the orientation is referred to as an orientation d_{B}, the period along the orientation d_{B} is 3 nm to 100 nm and the maximum ΔXod_{B} of a change in the amount x of Al in a plane perpendicular to the orientation d_{B} is 0.01 or less are formed, strain is present in two directions in the crystal grains, resulting in an improvement in toughness. Furthermore, as the boundary between the area A and the area B is formed in one plane among the equivalent crystal planes expressed by {110}, misfits at the boundary between the area A and the area B do not occur, and thus high toughness can be maintained.

Lattice Constant a of Cubic Crystal grains in Layer of Complex Carbonitride:
When the lattice constant a of the cubic crystal grains is obtained by conducting an X-ray diffraction test on the layer of a complex carbonitride using an X-ray diffraction apparatus and Cu-Kα radiation as a radiation source, higher hardness and high thermal conductivity are achieved when the lattice constant a of the cubic crystal grains satisfies a relationship of 0.05a_{TiN} + 0.95a_{AlN} ≤ a ≤ 0.4a_{TiN} + 0.6a_{AlN} for the lattice constant a_{TiN}: 4.24173 Å of cubic TiN (JCPDS 00-038-1420) and the lattice constant a_{AlN}: 4.045 Å of cubic AlN (JCPDS 00-046-1200). Accordingly, in addition to excellent wear resistance, excellent thermal shock resistance is provided.

Area Ratio of Columnar Structure Constituted by Individual Crystal grains Having Cubic Structure in Layer of Complex Nitride or Complex Carbonitride:
When the area ratio of the columnar structure constituted by individual crystal grains having a cubic structure is lower than 70% by area, the hardness is relatively reduced, which is not preferable.

In addition, in the layer of a complex nitride or complex carbonitride of the present invention, even in a case where a Ti compound layer that is formed of one layer or two or more layers of a Ti carbide layer, a Ti nitride layer, a Ti carbonitride layer, a Ti oxycarbide layer, and a Ti oxycarbonitride layer and has an average total layer thickness of 0.1 µm to 20 µm is included as the lower layer, and/or even in a case where an aluminum oxide layer having an average layer thickness of 1 µm to 25 µm is included as the upper layer, the above-described characteristics are not impaired. In addition, by using these known lower and upper layers in combination, better characteristics can be created in combination with the effects of these layers. In a case where the Ti compound layer that is formed of one layer or two or more layers of a Ti carbide layer, a Ti nitride layer, a Ti carbonitride layer, a Ti oxycarbide layer, and a Ti oxycarbonitride layer is included as the lower layer, when the average total layer thickness of the Ti compound layer is greater than 20 µm, the crystal grains easily coarsen and chipping easily occurs. In addition, in a case where the aluminum oxide layer is included as the upper layer, when the average total layer thickness of the aluminum oxide layer is greater than 25 µm, the crystal grains easily coarsen and chipping easily occurs. On the other hand, when the lower layer is smaller than 0.1 µm, the effect of improving the adhesion of the layer of a complex nitride or complex carbonitride of the present invention to the lower layer cannot be expected. Furthermore, when the upper layer is smaller than 1 µm, the effect of the film formation of the upper layer on an improvement in wear resistance is insufficient.

### Advantageous Effects of Invention

According to the present invention, in the surface-coated cutting tool in which the hard coating layer is provided on the surface of the tool body made of any of tungsten carbide-based cemented carbide, titanium carbonitride-based cermet, and a cubic boron nitride-based ultrahigh-pressure sintered body, the hard coating layer includes at least a layer of a complex nitride or complex carbonitride of Ti, Al, and Me, the layer being formed to an average layer thickness of 1 µm to 20 µm in a chemical vapor deposition method, and in a case where the layer is expressed by the composition formula: (Ti_{1-x-y}AlₓMe_{y})(C_{z}N_{1-z}), an average amount Xavg of Al in a total amount of Ti, Al, and Me, an average amount Yavg of Me in the total amount of Ti, Al, and Me, and an average amount Zavg of C in a total amount of C and N (here, each of Xavg, Yavg, and Zavg is in atomic ratio) satisfy 0.60 ≤ Xavg, 0.005 ≤ Yavg ≤ 0.10, 0 ≤ Zavg ≤ 0.005, and 0.605 ≤ Xavg + Yavg ≤ 0.95. The layer of a complex nitride or complex carbonitride includes at least a phase (cubic crystal phase) of a complex nitride or complex carbonitride having an NaCl type face-centered cubic structure. In a case where crystal orientations of crystal grains of the complex nitride or complex carbonitride of Ti, Al, and Me having a cubic structure are analyzed in a longitudinal sectional direction using an electron backscatter diffraction apparatus, when an inclined angle frequency distribution is obtained by measuring inclined angles of normal lines of {100} planes which are crystal planes of the crystal grains with respect to a normal direction of the surface of the tool body, dividing inclined angles in a range of 0 degrees to 45 degrees with respect to the normal direction among the inclined angles into intervals of 0.25 degrees, and aggregating frequencies present in the respective divisions, a highest peak is present in an inclined angle division in a range of 0 degrees to 12 degrees, and a sum of frequencies that are present in the range of 0 degrees to 12 degrees has a proportion of 35% or more in a total of the frequencies in the inclined angle frequency distribution. In the crystal grains having a cubic crystal structure, a periodic concentration variation of Ti, Al, and Me in the composition formula: (Ti_{1-x-y}AlₓMe_{y})(C_{z}N_{1-z}) is present, and in a case where an average value of local maximum of values of periodically varying x of an amount x of Al is referred to as Xmax and an average value of local minimum of the values of periodically varying x of the amount x of Al is referred to as Xmin, a difference Δx between Xmax and Xmin is 0.03 to 0.25. In the crystal grains having an NaCl type face-centered cubic structure in which the periodic concentration variation of Ti, Al, and Me is present, a period along the normal direction of the surface of the tool body is 3 nm to 100 nm. Accordingly, strain occurs in the crystal grains having the cubic crystal structure of the complex nitride or complex carbonitride. Therefore, the hardness of the crystal grains is improved, and the toughness thereof is improved while high wear resistance is maintained.

As a result, the effect of improving chipping resistance is exhibited, excellent cutting performance is exhibited during long-term use compared to a hard coating layer in the related art, and thus an increase in the service life of the coated tool is achieved.

### Brief Description of Drawings

Fig. 1 is a film configuration schematic view schematically illustrating the section of a layer of a complex nitride or complex carbonitride of Ti, Al, and Me included in a hard coating layer of the present invention.
Fig. 2 is a schematic view illustrating a case where an inclined angle of a normal line of a {100} plane which is a crystal plane of crystal grains with respect to a normal line of the surface of a tool body (a direction perpendicular to the surface of the tool body in a polished section) is 0 degrees in Fig. 2(a) and 45 degrees in Fig. 2(b).
Fig. 3(a) is a graph showing an example of an inclined angle frequency distribution obtained for crystal grains having a cubic structure in the section of a layer of a complex nitride or a layer of a complex carbonitride of Ti and Al included in the hard coating layer of the present invention, and Fig. 3(b) is a graph showing an example of an inclined angle frequency distribution obtained for crystal grains having a cubic structure in the section of a layer of a complex nitride or a layer of a complex carbonitride of Ti and Al included in a hard coating layer of an embodiment of a comparative example.
Fig. 4 is a schematic view schematically illustrating that, in crystal grains having a cubic crystal structure in which a periodic concentration variation of Ti, Al, and Me is present in the section of the layer of a complex nitride or the layer of a complex carbonitride of Ti, Al, and Me included in the hard coating layer corresponding to an embodiment of the present invention, the periodic concentration variation of Ti, Al, and Me is present along one orientation among equivalent crystal orientations expressed by <001> of the cubic crystal grains, and a change in the amount x of Al in a plane perpendicular to the orientation is small.
Fig. 5 shows an example of a graph of the periodic concentration variation x of Al with respect to the sum of Ti, Al, and Me as a result of line analysis performed by energy-dispersive X-ray spectroscopy (EDS) using a transmission electron microscope on the crystal grains having a cubic crystal structure in which the periodic concentration variation of Ti, Al, and Me is present in the section of the layer of a complex nitride or the layer of a complex carbonitride of Ti, Al, and Me included in the hard coating layer corresponding to the embodiment of the present invention.
Fig. 6 is a schematic view schematically illustrating that, regarding the crystal grains having a cubic crystal structure in which the periodic concentration variation of Ti, Al, and Me is present in the section of the layer of a complex nitride or the layer of a complex carbonitride of Ti, Al, and Me included in the hard coating layer corresponding to the embodiment of the present invention, an area A and an area B are present in the crystal grains.

### Description of Embodiments

The present invention has a configuration in which, in a surface-coated cutting tool in which a hard coating layer is provided on a surface of a cemented carbide tool body, that is, a tool body made of any of tungsten carbide-based cemented carbide, titanium carbonitride-based cermet, and a cubic boron nitride-based ultrahigh-pressure sintered body, the hard coating layer includes at least a layer of a complex nitride or complex carbonitride of Ti, Al, and Me, the layer being formed to an average layer thickness of 1 µm to 20 µm in a chemical vapor deposition method, and in a case where the layer is expressed by the composition formula: (Ti_{1-x-y}AlₓMe_{y})(C_{z}N_{1-z}), an average amount Xavg of Al of the layer in a total amount of Ti, Al, and Me, an average amount Yavg of Me in the total amount of Ti, Al, and Me, and an average amount Zavg of C in a total amount of C and N (here, each of Xavg, Yavg, and Zavg is in atomic ratio) satisfy 0.60 ≤ Xavg, 0.005 ≤ Yavg ≤ 0.10, 0 ≤ Zavg ≤ 0.005, and 0.605 ≤ Xavg + Yavg ≤ 0.95, crystal grains constituting the layer of a complex nitride or complex carbonitride include at least crystal grains having a cubic crystal structure, in a case where crystal orientations of the crystal grains of the complex nitride or complex carbonitride of Ti, Al, and Me having a cubic structure are analyzed in a longitudinal sectional direction using an electron backscatter diffraction apparatus, when an inclined angle frequency distribution is obtained by measuring inclined angles of normal lines of {100} planes which are crystal planes of the crystal grains with respect to a normal direction of the surface of the tool body, dividing inclined angles in a range of 0 degrees to 45 degrees with respect to the normal direction among the inclined angles into intervals of 0.25 degrees, and aggregating frequencies present in the respective divisions, a highest peak is present in an inclined angle division in a range of 0 degrees to 12 degrees, and a sum of frequencies that are present in the range of 0 degrees to 12 degrees has a proportion of 35% or more in a total of the frequencies in the inclined angle frequency distribution, in the crystal grains having a cubic crystal structure, a periodic concentration variation of Ti, Al, and Me in the composition formula: (Ti_{1-x-y}AlₓMe_{y})(C_{z}N_{1-z}) is present, in a case where an average value of local maximum of values of periodically varying x of an amount x of Al is referred to as Xmax and an average value of local minimum of the values of periodically varying x of the amount x of Al is referred to as Xmin, a difference Δx between Xmax and Xmin is 0.03 to 0.25, and in the crystal grains having an NaCl type face-centered cubic structure in which the periodic concentration variation of Ti, Al, and Me is present, a period along the normal direction of the surface of the tool body is 3 nm to 100 nm. As long as the chipping resistance is improved, excellent cutting performance is exhibited during long-term use compared to a hard coating layer in the related art, and an increase in the service life of the coated tool is achieved, the specific embodiment may be any embodiment.

Next, an embodiment of a coated tool of the present invention will be described in detail using examples.

### Example 1

As raw material powders, a WC powder, a TiC powder, a TaC powder, an NbC powder, a Cr₃C₂ powder, and a Co powder, all of which had an average grain size of 1 µm to 3 µm, were prepared, and the raw material powders were mixed in mixing compositions shown in Table 1. Wax was further added thereto, and the mixture was blended in acetone by a ball mill for 24 hours and was decompressed and dried. Thereafter, the resultant was press-formed into green compacts having predetermined shapes at a pressure of 98 MPa, and the compacts were sintered in a vacuum at 5 Pa under the condition that the green compacts were held at a predetermined temperature in a range of 1370°C to 1470°C for one hour. After the sintering, tool bodies A to C made of WC-based cemented carbide with insert shapes according to ISO standard SEEN1203AFSN were produced.

In addition, as raw material powders, a TiCN (TiC/TiN = 50/50 in terms of mass ratio) powder, an Mo₂C powder, a ZrC powder, an NbC powder, a WC powder, a Co powder, and an Ni powder, all of which had an average grain size of 0.5 µm to 2 µm, were prepared, and the raw material powders were mixed in mixing compositions shown in Table 2, were subjected to wet mixing by a ball mill for 24 hours, and were dried. Thereafter, the resultant was press-formed into green compacts at a pressure of 98 MPa, and the green compacts were sintered in a nitrogen atmosphere at 1.3 kPa under the condition that the green compacts were held at a temperature of 1500°C for one hour. After the sintering, a tool body D made of TiCN-based cermet with insert shapes according to ISO standard SEEN1203AFSN was produced.

Next, present invention coated tools 1 to 15 were produced by forming hard coating layers formed of (Ti_{1-x-y}AlₓMe_{y})(C_{z}N_{1-z}) layers having target layer thicknesses shown in Table 7, on the surfaces of the tool bodies A to D through a thermal CVD method for a predetermined time using a chemical vapor deposition apparatus
(a) under forming conditions shown in Table 4 in which a gas group A of NH₃ and H₂ and a gas group B of TiCl₄, Al(CH₃)₃, AlCl₃, MeClₙ (here, any of SiCl₄, ZrCl₄, BCl₃, VCl₄, and CrCl₂), NH₃, N₂, and H₂ were used and in each gas supply method, a reaction gas composition (% by volume with respect to the total amount of the gas group A and the gas group B) included a gas group A of NH₃: 3.5% to 4.0%, N₂: 0% to 5%, H₂: 55% to 60% and a gas group B of AlCl₃: 0.6% to 0.9%, TiCl₄: 0.2% to 0.3%, Al(CH₃)₃: 0% to 0.5%, MeClₙ (here, any of SiCl₄, ZrCl₄, BCl₃, VCl₄, and CrCl₂): 0.1% to 0.2%, N₂: 0.0% to 12.0%, H₂: the remainder, a reaction atmosphere pressure was 4.5 kPa to 5.0 kPa, a reaction atmosphere temperature was 700°C to 900°C, a supply period was 1 second to 5 seconds, a gas supply time per one period was 0.15 seconds to 0.25 seconds, and a phase difference between gas supply A and gas supply B was 0.10 seconds to 0.20 seconds.

In addition, any of a lower layer and an upper layer shown in Table 6 was formed on the present invention coated tools 6 to 13 under forming conditions shown in Table 3.

In addition, for the purpose of comparison, hard coating layers including a layer of a complex nitride or complex carbonitride of Ti, Al, and Me were deposited on the surfaces of the tool bodies A to D to have target layer thicknesses (µm) shown in Fig. 8 under the conditions shown in Table 5. At this time, comparative coated tools 1 to 15 were produced by forming the hard coating layers so that the composition of the reaction gas on the surface of the tool body was not changed over time during a process of forming a (Ti_{1-x-y}AlₓMe_{y})(C_{z}N_{1-z}) layer.

In addition, like the present invention coated tools 6 to 13, any of a lower layer and an upper layer shown in Table 6 was formed on the comparative coated tools 6 to 13 under the forming conditions shown in Table 3.

Regarding the layer of a complex nitride or complex carbonitride of Ti, Al, and Me included in the hard coating layer of the present invention coated tools 1 to 15 and the comparative coated tools 1 to 15, in a state where the section of the hard coating layer in the direction perpendicular to the surface of the tool body was polished into a polished surface, the polished surface was set in the body tube of a field emission scanning electron microscope, and an electron beam was emitted toward each of the crystal grains having a cubic crystal lattice, which were present in a measurement range of the polished section at an incident angle of 70 degrees with respect to the polished surface at an acceleration voltage of 15 kV and an emission current of 1 nA. Regarding the hard coating layer in a measurement range of a length of 100 µm in the direction parallel to the surface of the tool body and a distance of equal to or less than the film thickness along the section in the direction perpendicular to the surface of the tool body, inclined angles of normal lines of {100} planes which were crystal planes of the crystal grains with respect to the normal line (the direction perpendicular to the surface of the body in the polished section) to the surface of the body were measured using an electron backscatter diffraction imaging device at an interval of 0.01 µm/step. On the basis of the measurement results, measured inclined angles in a range of 0 degrees to 45 degrees among the measured inclined angles were divided into intervals of 0.25 degrees, frequencies in the respective divisions were aggregated, and the presence of the peaks of the frequencies present in a range of 0 degrees to 12 degrees was checked. In addition, the proportion of the frequencies present in the range of 0 degrees to 12 degrees was obtained.

In addition, regarding a layer of a complex nitride or complex carbonitride of Ti, Al, and Me included in the hard coating layers of the present invention coated tools 1 to 15 and the comparative coated tools 1 to 15, a plurality of visual fields were observed using a scanning electron microscope (at a magnification of 5,000x and 20,000x).

Regarding the present invention coated tools 1 to 15, as illustrated in a film configuration schematic view in Fig. 1, a (Ti_{1-x-y}AlₓMe_{y})(C_{z}N_{1-z}) layer having a columnar structure including cubic crystals or a mixed phase of cubic crystals and hexagonal crystals was confirmed. In addition, by performing surface analysis through energy-dispersive X-ray spectroscopy (EDS) using a transmission electron microscope, it was confirmed that a periodic distribution of Ti, Al, and Me was present in the cubic crystal grains.

Furthermore, by using the results of the surface analysis performed on the present invention coated tools 1 to 15 and the comparative coated tools 1 to 15 through EDS using the transmission electron microscope, the average value of local maximum of x in a period of x for five periods of the cubic crystal grains present in the layer of a complex nitride or complex carbonitride was referred to as Xmax and the average value of local minimum of x in the period of x for the same five periods was referred to as Xmin, the difference Δx (= Xmax - Xmin) therebetween was obtained.

Regarding the present invention coated tools 1 to 15, it was confirmed that the value of Δx was 0.03 to 0.25.

The section of each of constituent layers of the present invention coated tools 1 to 15 and the comparative coated tools 1 to 15 in the direction perpendicular to the tool body was measured using a scanning electron microscope (at a magnification of 5,000x). An average layer thickness was obtained by measuring and averaging the layer thicknesses of five points in an observation visual field. All of the results showed substantially the same average layer thicknesses as the target layer thicknesses shown in Tables 7 and 8.

In addition, regarding the average amount of Al and the average amount of Me of the layer of a complex nitride or complex carbonitride of the present invention coated tools 1 to 15 and the comparative coated tools 1 to 15, a sample, of which the surface was polished, was irradiated with electron beams from the sample surface side, and the average Al amount Xavg of Al and the average amount Yavg of Me were obtained by averaging 10 points of the analytic result of obtained characteristic X-rays, using an electron probe micro-analyzer (EPMA).

The average amount Zavg of C was obtained by secondary ion mass spectrometry (SIMS). Ion beams were emitted toward a range of 70 µm × 70 µm from the sample surface side, and the concentration of components emitted by a sputtering action was measured in a depth direction. The average amount Zavg of C represents the average value of the layer of a complex nitride or complex carbonitride of Ti, Al, and Me in the depth direction. However, the amount of C excludes an unavoidable amount of C, which was included even though gas containing C was not intentionally used as a gas raw material. Specifically, the amount (atomic ratio) of the component C contained in the layer of a complex nitride or complex carbonitride in a case where the amount of supplied Al(CH₃)₃ was set to 0 was obtained as the unavoidable amount of C, and a value obtained by subtracting the unavoidable amount of C from the amount (atomic ratio) of the component C contained in the layer of a complex nitride or complex carbonitride obtained in a case where Al(CH₃)₃ was intentionally supplied was obtained as Zavg.

In addition, regarding the present invention coated tools 1 to 15 and the comparative coated tools 1 to 15, the individual crystal grains in the (Ti_{1-x-y}AlₓMe_{y})(C_{z}N_{1-z}) layer included in the layer of a complex nitride or complex carbonitride, which were present in a range of a length of 10 µm in a direction parallel to the surface of the tool body were observed from the film section side perpendicular to the surface of the tool body using a scanning electron microscope (at a magnification of 5,000x and 20,000x) in the sectional direction as the direction perpendicular to the tool body, grain widths w in the direction parallel to the surface of the body and grain lengths 1 in the direction perpendicular to the surface of the body were measured to calculate the aspect ratio a(= l/w) of each of the crystal grains. The average value of the aspect ratios a obtained for the individual crystal grains was calculated as an average aspect ratio A. In addition, the average value of the grain widths w obtained for the individual crystal grains was calculated as an average grain width W.

In addition, using an electron backscatter diffraction apparatus, in a state where the section of the hard coating layer including the layer of a complex nitride or complex carbonitride of Ti, Al, and Me in the direction perpendicular to the surface of the tool body was polished into a polished surface, the polished surface was set in the body tube of a field emission scanning electron microscope, an electron beam was emitted toward each of the crystal grains, which were present in a measurement range of the polished section, at an incident angle of 70 degrees with respect to the polished surface at an acceleration voltage of 15 kV and an emission current of 1 nA, and regarding the hard coating layer at a length of 100 µm in the direction parallel to the surface of the tool body, an electron backscatter diffraction image was measured at an interval of 0.01 µm/step. By analyzing the crystal structure of the individual crystal grains, a cubic crystal structure or a hexagonal crystal structure were classified to confirm that a cubic phase of the complex nitride or complex carbonitride was included in the layer of a complex nitride or complex carbonitride of Ti, Al, and Me. Furthermore, the area ratio of the cubic crystal phase included in the layer was obtained.

Moreover, a small area of the layer of a complex nitride or complex carbonitride was observed by using the transmission electron microscope, and surface analysis from the section side was performed using energy-dispersive X-ray spectroscopy (EDS). The presence or absence of a periodic concentration variation of Ti, Al, and Me in the composition formula: (Ti_{1-x-y}AlₓSi_{y})(C_{z}N_{1-z}) in the crystal grains having the cubic crystal structure was checked. In a case where the concentration variation was present, by performing electron beam diffraction on the crystal grains, it was confirmed that the periodic concentration variation of Ti, Al, and Me was present along one orientation among equivalent crystal orientations expressed by <001> of the cubic crystal grains. Line analysis through EDS along the orientation was performed on a section for five periods, the average value of local maximum of the periodic concentration variation of Al with respect to the sum of Ti, Al, and Me was obtained as Xmax, the average value of local minimum of the periodic concentration variation of Al with respect to the sum of Ti, Al, and Me in the same section was obtained as Xmin, and the difference Δx (= Xmax - Xmin) therebetween was obtained.

In addition, line analysis along the direction perpendicular to one orientation among the equivalent crystal orientations expressed by <001> of the cubic crystal grains, in which the periodic concentration variation of Ti, Al, and Me was present, was performed on a section corresponding to the distance for the five periods. The difference between the maximum and the minimum of the amount x of Al in the section was obtained as the maximum ΔXo of a change in a plane perpendicular to the one orientation among the equivalent crystal orientations expressed by <001> of the cubic crystal grains, in which the periodic concentration variation of Ti, Al, and Me was present.

Furthermore, regarding the crystal grains in which the area A and the area B were present in the crystal grains, for each of the area A and the area B, as described above, the maximum Δx (= Xmax - Xmin) of the difference between the average value Xmax of local maximum of the periodic concentration variation for the five periods of Al with respect to the sum of Ti, Al, and Me and the value Xmin of the average value of local minimum thereof is obtained. In addition, the difference between the maximum and the minimum of the amount x of Al with respect to the sum of Ti, Al, and Me in the plane perpendicular to the one orientation among the equivalent crystal orientations expressed by <001> of the cubic crystal grains, in which the periodic concentration variation of Ti, Al, and Me was present, was obtained as the maximum of a change therein.

That is, in a case where the periodic concentration variation of Ti, Al, and Me of the area A was present along one orientation among the equivalent crystal orientations expressed by <001> of the cubic crystal grains, and the orientation is referred to as an orientation d_{A}, the period of the concentration variation along the orientation d_{A} was obtained. In addition, line analysis along the direction perpendicular to the orientation d_{A} was performed on a section corresponding to the distance for the five periods, and the difference between the maximum and the minimum of the amount x of Al in the section was obtained as the maximum Δ Xod_{A} of a change in the plane perpendicular to the one orientation among the equivalent crystal orientations expressed by <001> of the cubic crystal grains, in which the periodic concentration variation of Ti, Al, and Me was present.

In addition, in a case where the periodic concentration variation of Ti, Al, and Me of the area B was present along one orientation among the equivalent crystal orientations expressed by <001> of the cubic crystal grains, and the orientation is referred to as an orientation d_{B}, the period of the concentration variation along the orientation d_{B} was obtained. In addition, line analysis along the direction perpendicular to the orientation d_{B} was performed on the section corresponding to the distance for the five periods, and the difference between the maximum and the minimum of the amount x of Al in the section was obtained as the maximum Δ Xod_{B} of a change in the plane perpendicular to the one orientation among the equivalent crystal orientations expressed by <001> of the cubic crystal grains, in which the periodic concentration variation of Ti, Al, and Me was present.

In addition, regarding the present invention coated tools 1 to 15, it was confirmed that d_{A} and d_{B} were perpendicular to each other, and the boundary between the area A and the area B was formed in one plane among equivalent crystal planes expressed by {110}.

The period was checked with at least one crystal grain in the observation visual field of the small area of the layer of a complex nitride or complex carbonitride using the transmission electron microscope. In addition, regarding the crystal grains in which the area A and the area B were present in the crystal grains, the average of values evaluated for each of the area A and the area B of at least one crystal grain in the observation visual field of the small area of the layer of a complex nitride or complex carbonitride using the transmission electron microscope was calculated and obtained.

Tables 7 and 8 show the results of various measurements described above.

**[Table 1]**

| Type | | Mixing composition (mass%) | | | | | |
|---|---|---|---|---|---|---|---|
| | | Co | TiC | TaC | NbC | Cr₃C₂ | WC |
| Tool body | A | 8.0 | 1.5 | - | 3.0 | 0.4 | Remainder |
| | B | 8.5 | - | 1.8 | 0.2 | - | Remainder |
| | C | 7.0 | - | - | - | - | Remainder |

**[Table 2]**

| Type | | Mixing composition (mass%) | | | | | | |
|---|---|---|---|---|---|---|---|---|
| | | Co | Ni | ZrC | NbC | Mo₂C | WC | TiCN |
| Tool body | D | 8 | 5 | 1 | 6 | 6 | 10 | Remainder |

**[Table 3]**

| Constituent layers of hard coating layer | | | Forming conditions (pressure of reaction atmosphere is expressed as kPa and temperature is expressed as °C) | | |
|---|---|---|---|---|---|
| Type | | Formation symbol | Reaction gas composition (% by volume) | Reaction atmosphere | |
| | | | | Pressure | Temperature |
| (Ti_{1-x-y}AlₓMe_{y}) (C_{z}N_{1-z}) layer | | | See Tables 4 and 5 | | |
| Ti compound layer | TiC | TiC | TiCl₄: 2%, CH₄: 10%, H₂: remainder | 7 | 850 |
| | TiN | TiN | TiCl₄: 4.2%, N₂: 30%, H₂: remainder | 30 | 780 |
| | TiCN | TiCN | TiCl₄: 2%, CH₃CN: 0.7%, | 7 | 780 |
| | | | N₂: 10%, H₂: remainder | | |
| | TiCO | TiCO | TiCl₄: 4.2%, CO: 4%, H₂: remainder | 7 | 850 |
| | TiCNO | TiCNO | TiCl₄: 2%, CH₃CN: 0.7%, N₂: 10%, CO₂: 0.3%, H₂: remainder | 13 | 780 |
| Al₂O₃ layer | Al₂O₃ | Al₂O₃ | AlCl₃: 2.2%, CO₂: 5.5%, HCl: 2.2%, H₂S: 0.8%, H₂: remainder | 7 | 800 |

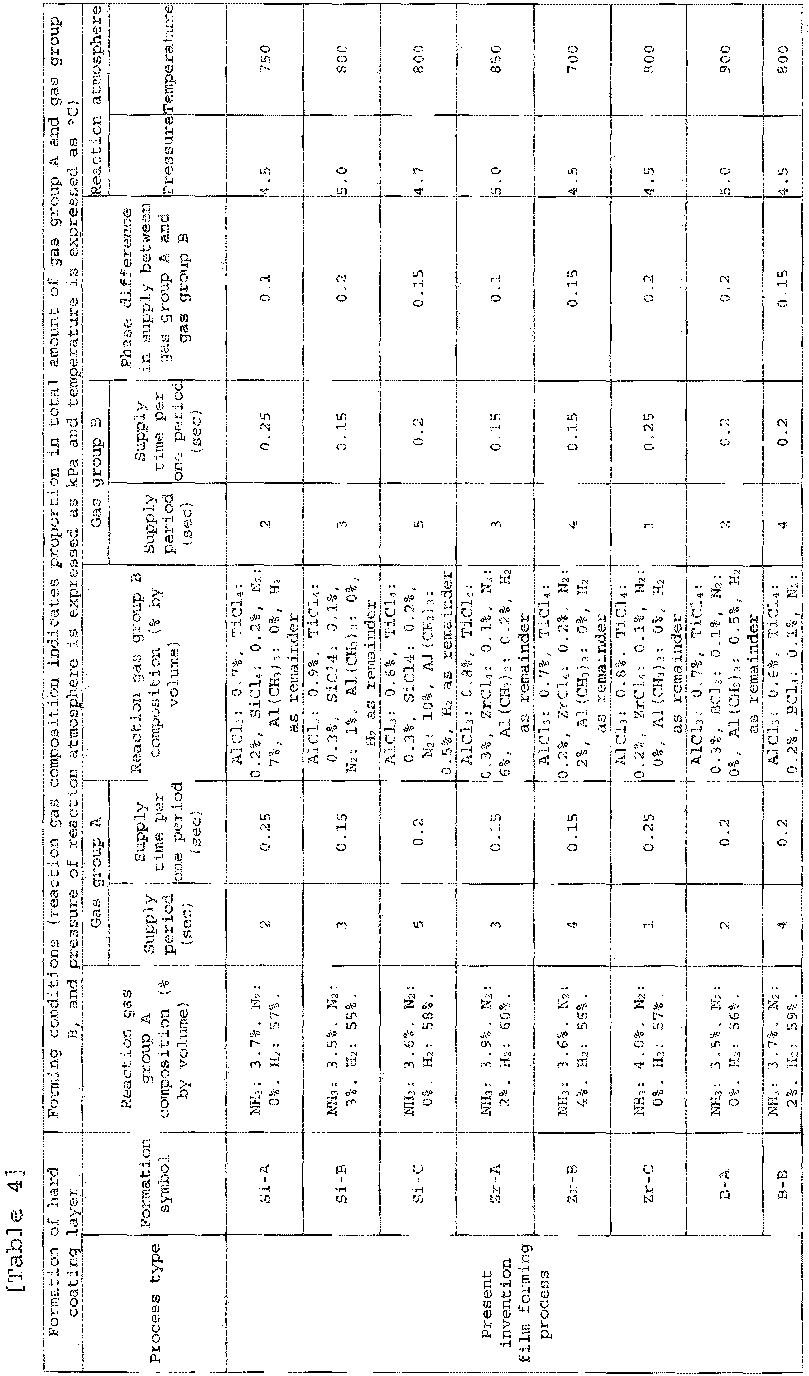

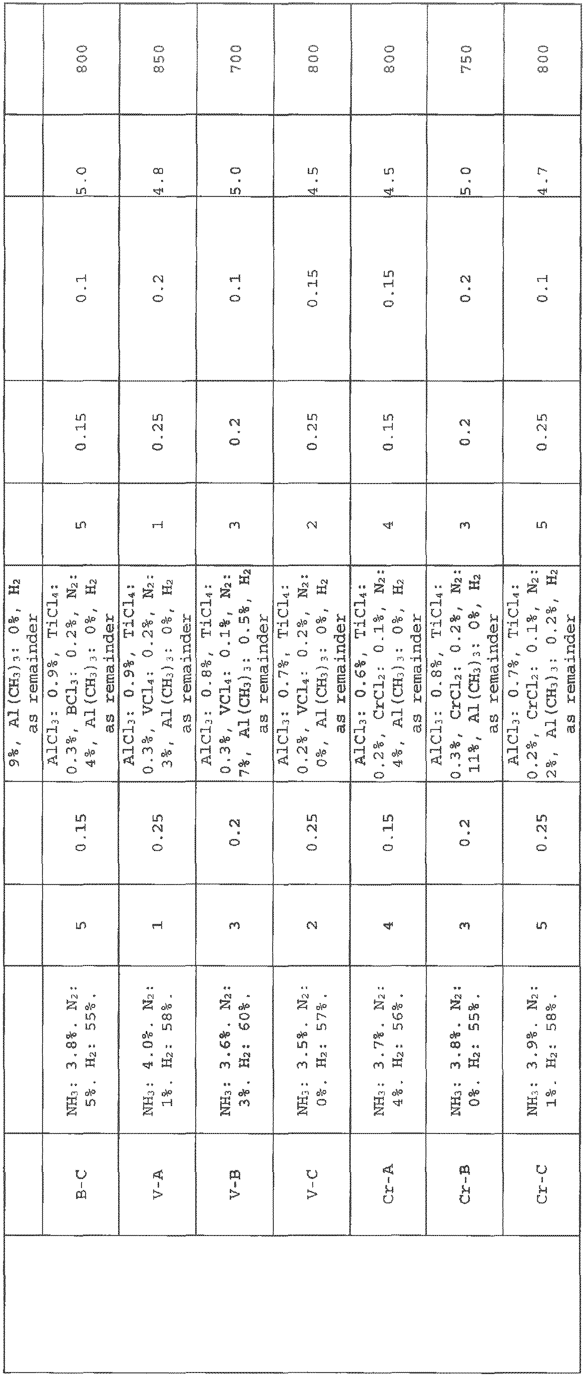

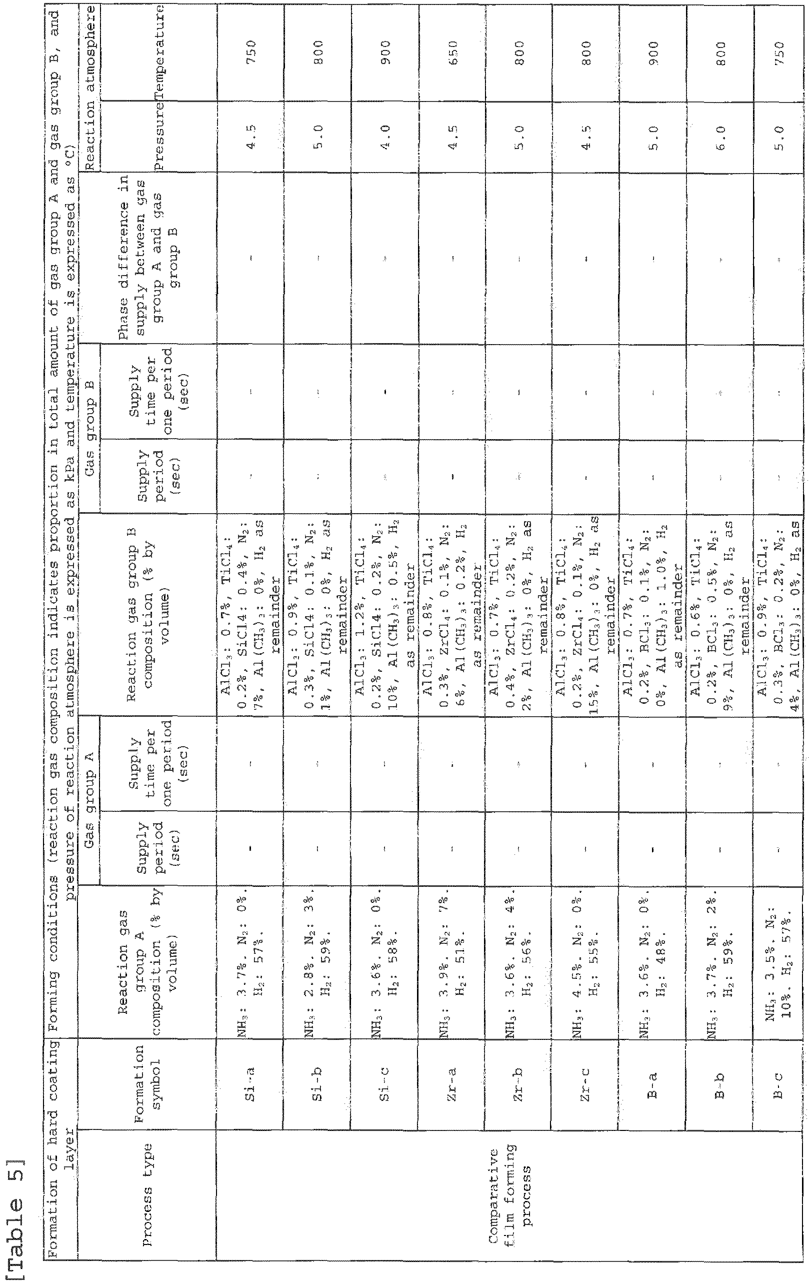

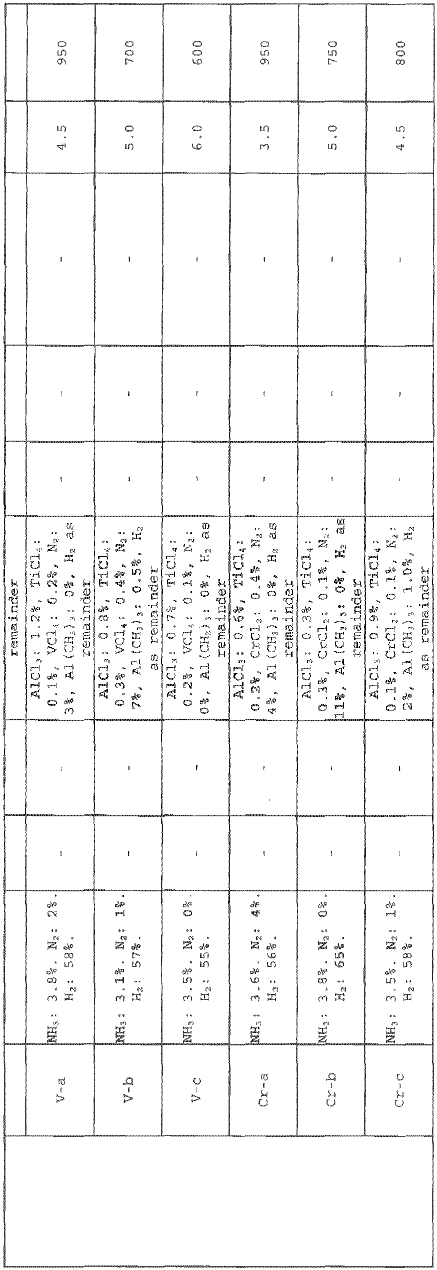

**[Table 6]**

| Type | | Hard coating layer (numerical value at the bottom indicates the average target layer thickness of the layer (µm) | | | |
|---|---|---|---|---|---|
| | | Lower layer | | Upper layer | |
| | | First layezr | Second layer | first layer | Second layer |
| | 1 | - | - | - | - |
| | 2 | - | - | - | - |
| | 3 | - | - | - | - |
| | 4 | - | - | - | - |
| | 5 | - | - | - | - |
| | 6 | TiC (0.5) | - | - | - |
| | 7 | TiN (0.3) | - | - | - |
| Present invention coated tool and comparative coated tool | 8 | TiN (0.5) | TiCN (0.4) | - | - |
| | 9 | TiN (0.3) | TiCN (2) | - | - |
| | 10 | - | - | Al₂O₃ (2.5) | - |
| | 11 | TiN (0.5) | - | TiCN (0.5) | Al₂O₃ (3) |
| | 12 | TiC (1) | - | TiCO (1) | Al₂O₃ (2) |
| | 13 | TiN(0.1) | - | TiCON (0.3) | Al₂O₃ (1) |
| | 14 | - | - | - | - |
| | 15 | - | - | - | - |

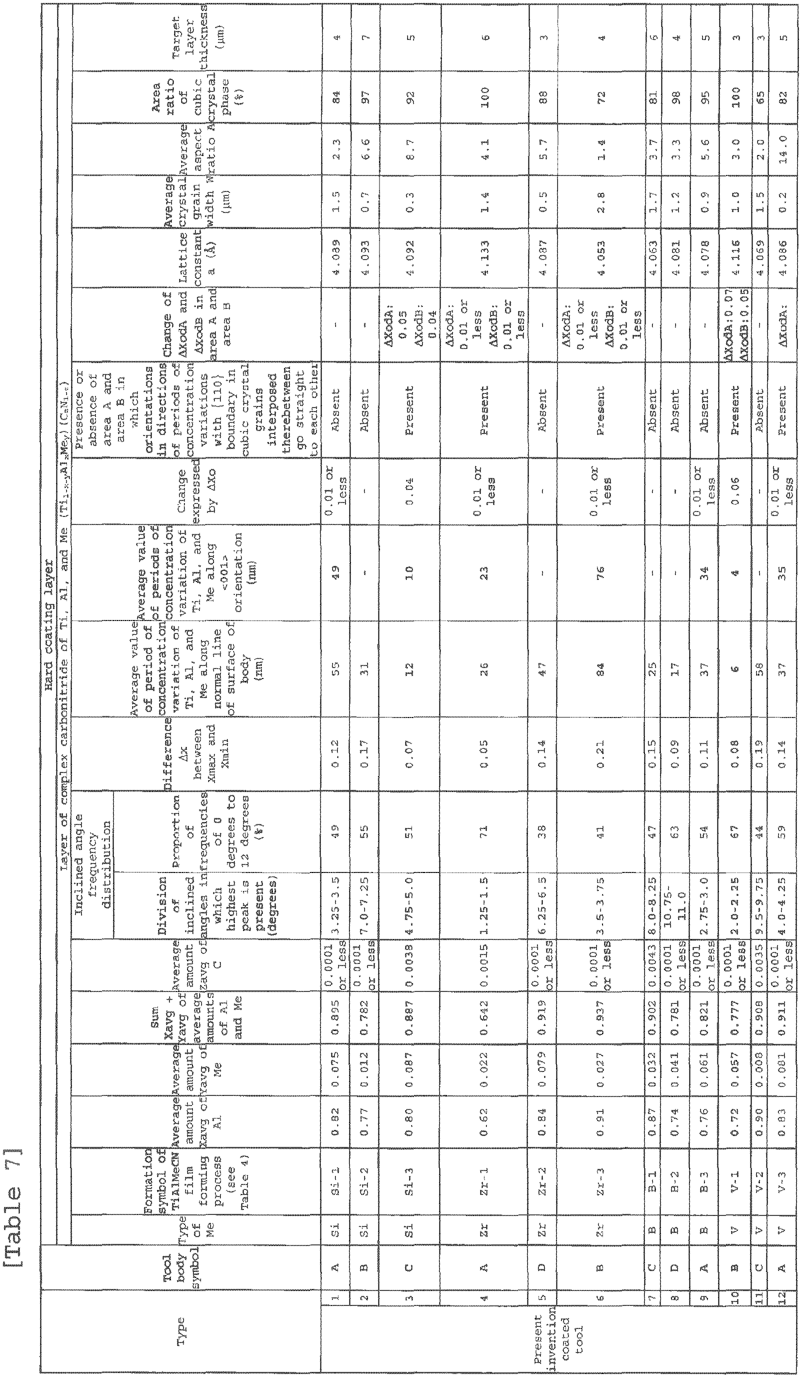

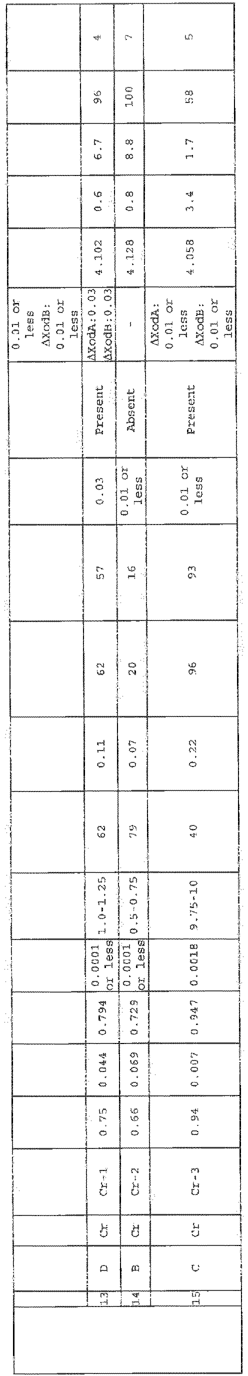

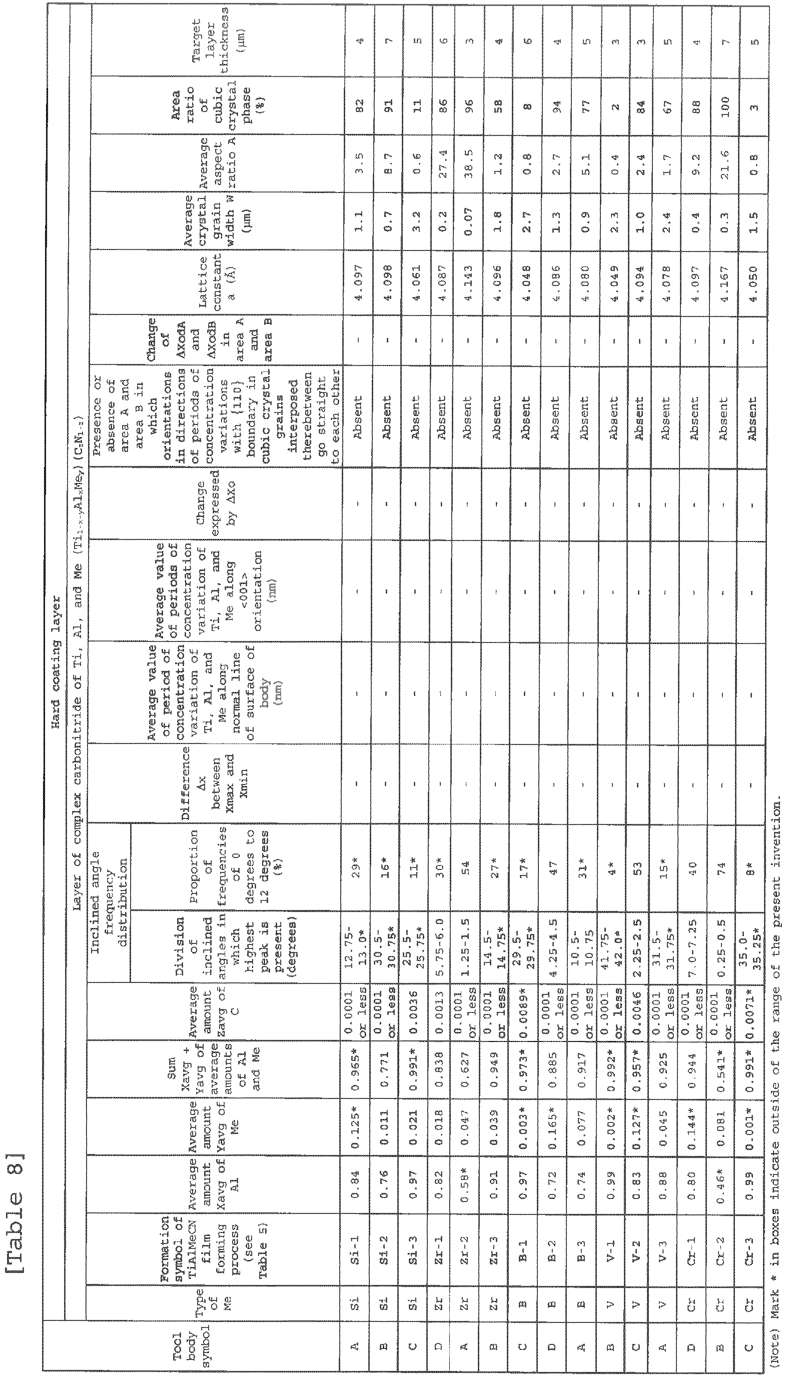

Next, in a state in which each of the various coated tools was clamped to a cutter tip end portion made of tool steel with a cutter diameter of 125 mm by a fixing tool, the present invention coated tools 1 to 15 and the comparative coated tools 1 to 15 were subjected to dry high-speed face milling, which is a type of high-speed intermittent cutting of alloy steel, and a center-cut cutting test, which will be described below, and the flank wear width of a cutting edge was measured.

Tool body: tungsten carbide-based cemented carbide, titanium carbonitride-based cermet
Cutting test: dry high-speed face milling, center-cut cutting work
Work material: a block material with a width of 100mm and a length of 400 mm of JIS SCM440
Rotational speed: 980 min⁻¹
Cutting speed: 385 m/min
Cutting depth: 1.2 mm
Feed per edge: 0.15 mm/edge
Cutting time: 8 minutes.

The cutting work test results are shown in Table 9.

**[Table 9]**

| Type | | Flank wear width (mm) | Type | | Cutting test results (min) |
|---|---|---|---|---|---|
| | 1 | 0.15 | | 1 | 5.8* |
| | 2 | 0.19 | | 2 | 5.7* |
| | 3 | 0.14 | | 3 | 5.5* |
| | 4 | 0.13 | | 4 | 6.4* |
| | 5 | 0.18 | | 5 | 6.5* |
| | 6 | 0.13 | | 6 | 6.0* |
| Present invention coated tool | 7 | 0.15 | Comparative coated tool | 7 | 5.4* |
| | 8 | 0.14 | | 8 | 7.3* |
| | 9 | 0.12 | | 9 | 7.1* |
| | 10 | 0.11 | | 10 | 5.7* |
| | 11 | 0.13 | | 11 | 6.9* |
| | 12 | 0.10 | | 12 | 7.0* |
| | 13 | 0.15 | | 13 | 6.8* |
| | 14 | 0.14 | | 14 | 5.6* |
| | 15 | 0.14 | | 15 | 4.7* |

| | | | | | |
|---|---|---|---|---|---|
| Mark * in boxes of comparative coated tools indicates a cutting time (min) until the end of a service life caused by the occurrence of chipping. | | | | | |

### Example 2

As raw material powders, a WC powder, a TiC powder, a ZrC powder, a TaC powder, an NbC powder, a Cr₃C₂ powder, a TiN powder, and a Co powder, all of which had an average grain size of 1 µm to 3 µm, were prepared, and the raw material powders were mixed in mixing compositions shown in Table 10. Wax was further added thereto, and the mixture was blended in acetone by a ball mill for 24 hours and was decompressed and dried. Thereafter, the resultant was press-formed into green compacts having predetermined shapes at a pressure of 98 MPa, and the green compacts were sintered in a vacuum at 5 Pa under the condition that the green compacts were held at a predetermined temperature in a range of 1370°C to 1470°C for one hour. After the sintering, each of tool bodies α to γ made of WC-based cemented carbide with insert shapes according to ISO standard CNMG120412 was produced by performing honing with R: 0.07 mm on a cutting edge portion.

In addition, as raw material powders, a TiCN (TiC/TiN = 50/50 in terms of mass ratio) powder, an NbC powder, a WC powder, a Co powder, and an Ni powder, all of which had an average grain size of 0.5 (µm to 2 µm, were prepared, and the raw material powders were mixed in mixing compositions shown in Table 11, were subjected to wet mixing by a ball mill for 24 hours, and were dried. Thereafter, the resultant was press-formed into a green compacts at a pressure of 98 MPa, and the green compacts was sintered in a nitrogen atmosphere at 1.3 kPa under the condition that the green compacts was held at a temperature of 1500°C for one hour. After the sintering, a tool body δ made of TiCN-based cermet with an insert shape according to ISO standard CNMG120412 was produced by performing honing with R: 0.09 mm on a cutting edge portion.

Subsequently, present invention coated tools 16 to 30 were produced by forming (Ti_{1-x-y}AlₓMe_{y}) (C_{z}N_{1-z}) layers shown in Table 13 on the surfaces of the tool bodies α to γ and the tool body δ through a thermal CVD method for a predetermined time using a chemical vapor deposition apparatus under the conditions shown in Table 4 in the same method as that in Example 1.

In addition, a lower layer and an upper layer shown in Table 12 were formed in the present invention coated tools 19 to 28 under the forming conditions shown in Table 3.

In addition, for the purpose of comparison, comparative coated tools 16 to 30 shown in Table 14 were produced by depositing a hard coating layer on the surfaces of the same tool bodies α to γ and the tool body δ to have target layer thicknesses shown in Table 14 under the conditions shown in Table 5 using a chemical vapor deposition apparatus, like the present invention coated tools. In addition, like the present invention coated tools 19 to 28, a lower layer and an upper layer shown in Table 12 was formed in the comparative coated tools 19 to 28 under the forming conditions shown in Table 3.

The section of each of constituent layers of the present invention coated tools 16 to 30 and the comparative coated tools 16 to 30 was measured using a scanning electron microscope (at a magnification of 5,000x). An average layer thickness was obtained by measuring and averaging the layer thicknesses of five points in an observation visual field. All of the results showed substantially the same average layer thicknesses as the target layer thicknesses shown in Tables 13 and 14.

In addition, regarding the hard coating layers of the present invention coated tools 16 to 30 and the comparative coated tools 16 to 30, using the same method as that described in Example 1, the average amount Xavg of Al, the average amount Yavg of Me, the average amount Zavg of C, the inclined angle frequency distribution, the difference Δx (= Xmax - Xmin) and period of the periodic concentration variation, the lattice constant a, the average grain width W and average aspect ratio A of crystal grains, and the area ratio of the cubic crystal phase to the crystal grains were obtained.

The results are shown in Tables 13 and 14.

**[Table 10]**

| Type | | Mixing composition (mass%) | | | | | | | |
|---|---|---|---|---|---|---|---|---|---|
| | | Co | TiC | ZrC | TaC | NbC | Cr₃C₂ | TiN | WC |
| Tool body | α | 6.5 | - | 1.5 | - | 2.9 | 0.1 | 1.5 | Remainder |
| | β | 7.6 | 2.6 | - | 4.0 | 0.5 | - | 1.1 | Remainder |
| | γ | 6.0 | - | - | - | - | - | - | Remainder |

**[Table 11]**

| Type | | Mixing composition (mass%) | | | | |
|---|---|---|---|---|---|---|
| | | Co | Ni | NbC | WC | TiCN |
| Tool body | δ | 11 | 4 | 6 | 15 | Remainder |

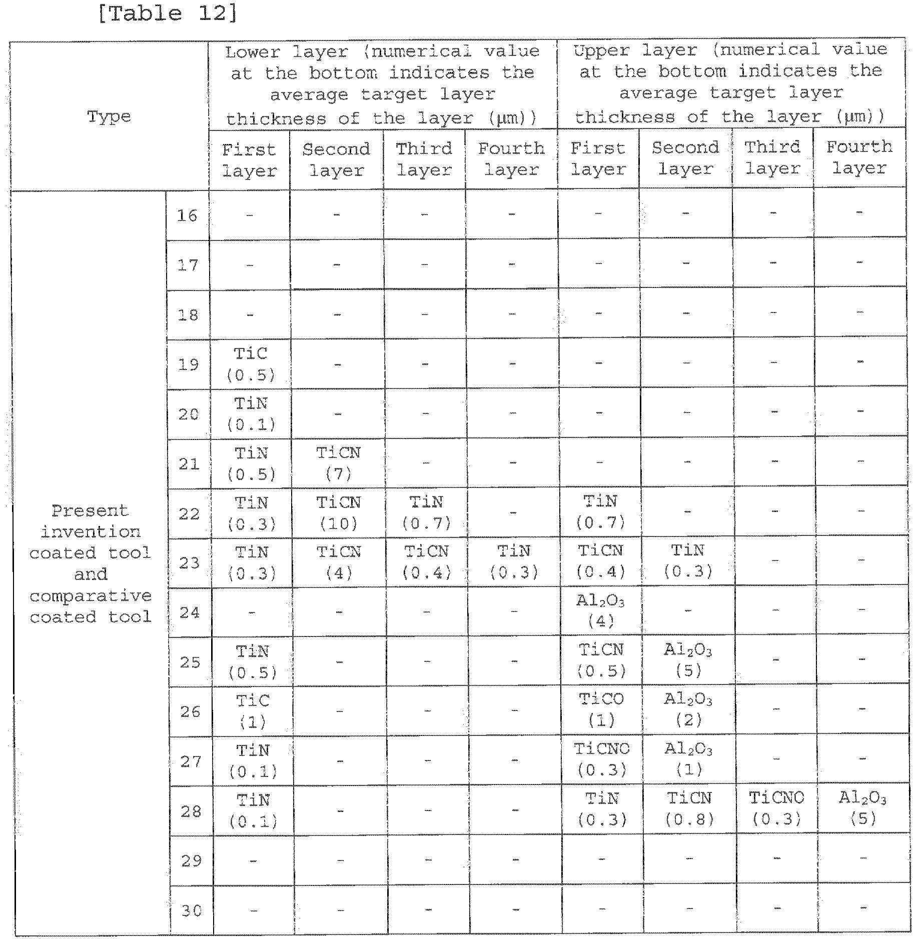

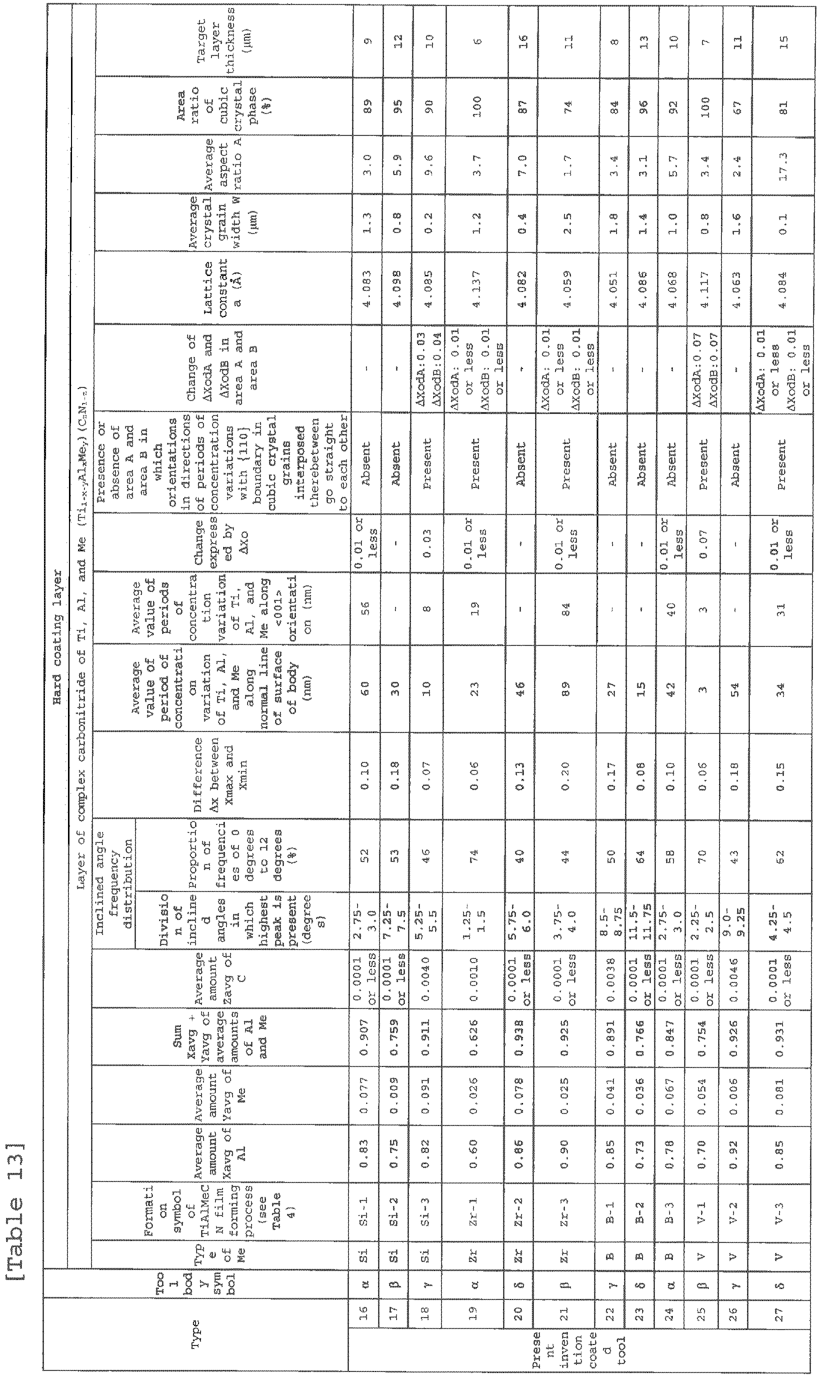

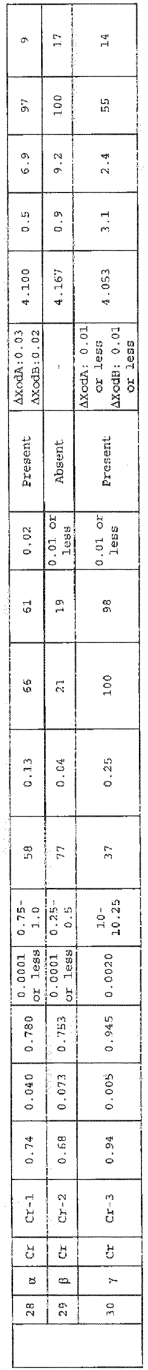

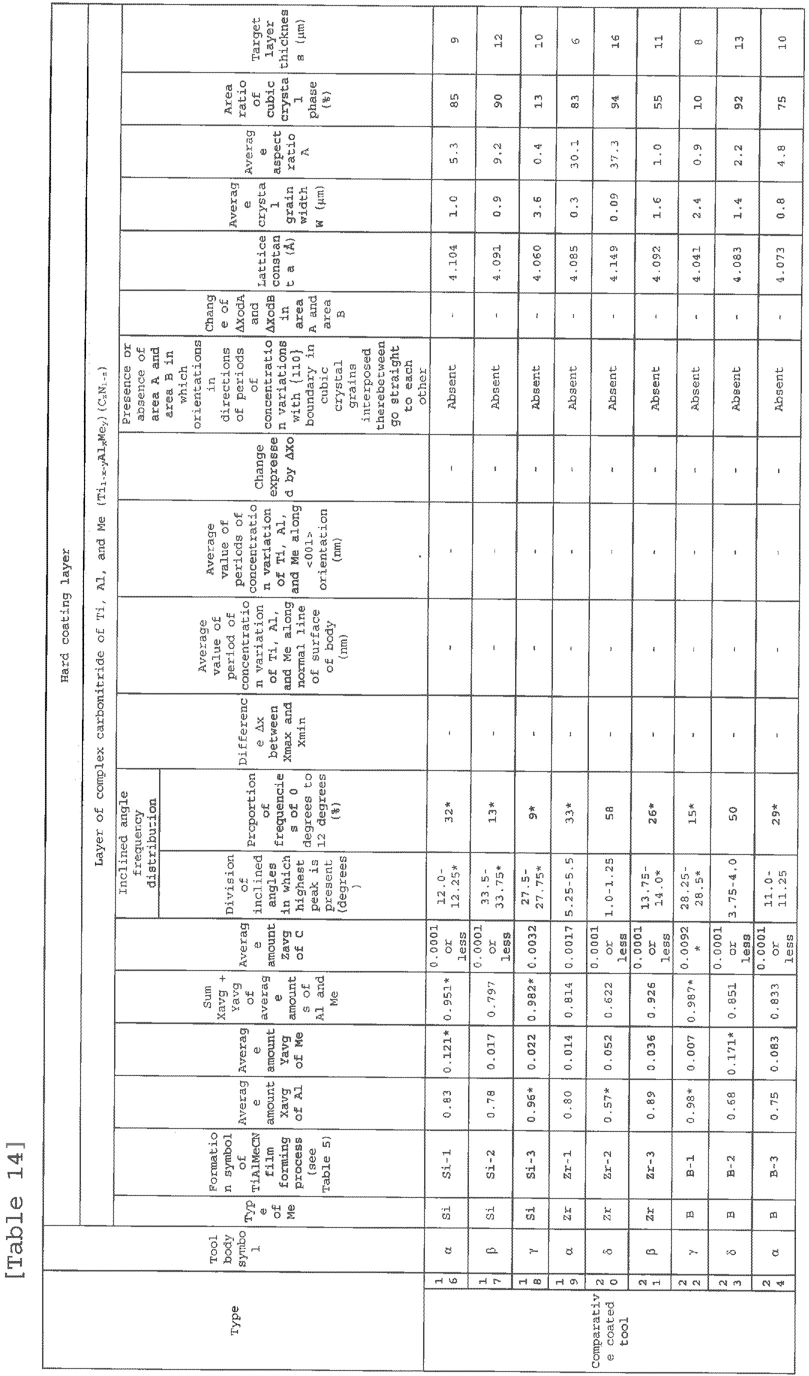

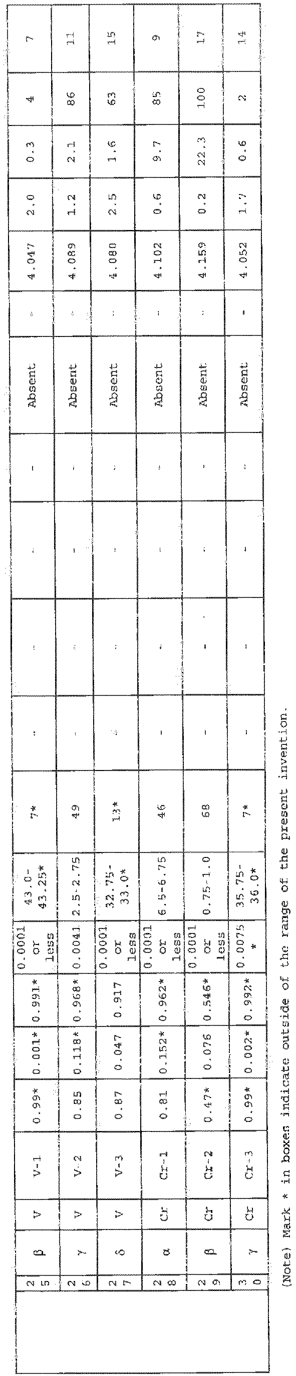

Next, in a state in which each of the various coated tools was screwed to a tip end portion of an insert holder made of tool steel by a fixing tool, the present invention coated tools 16 to 30 and the comparative coated tools 16 to 30 were subjected to a dry high-speed intermittent cutting test for alloy steel, and a wet high-speed intermittent cutting test for cast iron, which will be described below, and the flank wear width of a cutting edge was measured in either case.
Cutting conditions 1:
   Work material: a round bar with four longitudinal grooves formed at equal intervals in the longitudinal direction of JIS S45C
   Cutting speed: 380 m/min
   Cutting depth: 1.5 mm
   Feed: 0.1 mm/rev
   Cutting time: 5 minutes,
   (a typical cutting speed is 220 m/min)
Cutting conditions 2:
   Work material: a round bar with four longitudinal grooves formed at equal intervals in the longitudinal direction of JIS FCD700
   Cutting speed: 320 m/min
   Cutting depth: 1.5 mm
   Feed: 0.3 mm/rev
   Cutting time: 5 minutes,
   (a typical cutting speed is 200 m/min)

The results of the cutting test are shown in Table 15.

**[Table 15]**

| Type | | Flank wear width (mm) | | Type | | Cutting test results (min) | |
|---|---|---|---|---|---|---|---|
| | | Cutting conditions 1 | Cutting conditions 2 | | | Cutting conditions 1 | Cutting conditions 2 |
| | 16 | 0.15 | 0.16 | | 16 | 3.5* | 3.2* |
| | 17 | 0.19 | 0.18 | | 17 | 3.5* | 3.3* |
| | 18 | 0.15 | 0.14 | | 18 | 3.3* | 3.5* |
| | 19 | 0.14 | 0.12 | | 19 | 4.0* | 3.9* |
| | 20 | 0.17 | 0.18 | | 20 | 3.9* | 3.7* |
| | 21 | 0.13 | 0.12 | | 21 | 3.7* | 3.6* |
| | 22 | 0.14 | 0.13 | | 22 | 3.6* | 3.8* |
| Present invention coated tool | 23 | 0.15 | 0.14 | Comparative coated tool | 23 | 4.3* | 4.1* |
| | 24 | 0.11 | 0.12 | | 24 | 4.0* | 4.1* |
| | 25 | 0.12 | 0.11 | | 25 | 3.5* | 3.6* |
| | 26 | 0.13 | 0.12 | | 26 | 4.1* | 4.2* |
| | 27 | 0.10 | 0.09 | | 27 | 3.9* | 4.0* |
| | 28 | 0.17 | 0.16 | | 28 | 3.0* | 2.8* |
| | 29 | 0.14 | 0.15 | | 29 | 3.4* | 3.1* |
| | 30 | 0.13 | 0.14 | | 30 | 2.7* | 2.9* |

| | | | | | | | |
|---|---|---|---|---|---|---|---|
| Mark * in boxes of comparative coated tools indicates a cutting time (min) until the end of a service life caused by the occurrence of chipping. | | | | | | | |

### Example 3

As raw material powders, a cBN powder, a TiN powder, a TiCN powder, a TiC powder, an Al powder, and an Al₂O₃ powder, all of which had an average grain size of 0.5 µm to 4 µm, were prepared, and the raw material powders were mixed in mixing compositions shown in Table 16. The mixture was subjected to wet mixing by a ball mill for 80 hours and was dried. Thereafter, the resultant was press-formed into green compacts having dimensions with a diameter of 50 mm and a thickness of 1.5 mm at a pressure of 120 MPa, and the green compacts were then sintered in a vacuum at a pressure of 1 Pa under the condition that the green compacts were held at a predetermined temperature in a range of 900°C to 1300°C for 60 minutes, thereby producing cutting edge preliminary sintered bodies. In a state in which the preliminary sintered body was superimposed on a support piece made of WC-based cemented carbide, which was additionally prepared to contain Co: 8 mass% and WC: the remainder and have dimensions with a diameter of 50 mm and a thickness of 2 mm, the resultant was loaded in a typical ultrahigh-pressure sintering apparatus, and was subjected to ultrahigh-pressure sintering under typical conditions including a pressure of 4 GPa and a holding time of 0.8 hours at a predetermined temperature in a range of 1200°C to 1400°C. After the sintering, upper and lower surfaces were polished using a diamond grinding wheel, and were split into predetermined dimensions by a wire electric discharge machining apparatus. Furthermore, the resultant was brazed to a brazing portion (corner portion) of an insert body made of WC-based cemented carbide having a composition including Co: 5 mass%, TaC: 5 mass%, and WC: the remainder and a shape (a 80° rhombic shape with a thickness of 4.76 mm and an inscribed circle diameter of 12.7 mm) of ISO standard CNGA120412 using a brazing filler metal made of a Ti-Zr-Cu alloy having a composition including Zr: 37.5%, Cu: 25%, and Ti: the remainder in terms of mass%, and the outer circumference thereof was machined into predetermined dimensions. Thereafter, each of tool bodies a and b with an insert shape according to ISO standard CNGA120412 was produced by performing honing with a width of 0.13 mm and an angle of 25° on a cutting edge portion and performing finish polishing on the resultant.

**[Table 16]**

| Type | | Mixing composition (mass%) | | | | |
|---|---|---|---|---|---|---|
| | | TiN | TiC | Al | Al₂O₃ | cBN |
| Tool body | a | 50 | - | 5 | 3 | Remainder |
| | b | - | 50 | 4 | 3 | Remainder |

Subsequently, present invention coated tools 31 to 40 shown in Table 18 were produced by depositing hard coating layers including a (Ti_{1-x-y}AlₓMe_{y}) (C_{z}N_{1-z}) layer on the surfaces of the tool bodies a and b using a chemical vapor deposition apparatus to have target layer thicknesses under the conditions shown in Table 4 in the same method as that in Example 1.

In addition, a lower layer and an upper layer shown in Table 17 were formed in the present invention coated tools 34 to 39 under the forming conditions shown in Table 3.

In addition, for the purpose of comparison, comparative coated tools 31 to 40 shown in Table 19 were produced by depositing hard coating layers including a (TL_{1-x-y}AlₓMe_{y}) (C_{z}N_{1-z}) layer on the surfaces of the same tool bodies a and b to have target layer thicknesses under the conditions shown in Table 5 using a chemical vapor deposition apparatus.

In addition, like the present invention coated tools 34 to 39, a lower layer and an upper layer shown in Table 17 were formed in the comparative coated tools 34 to 39 under the forming conditions shown in Table 3.

The section of each of constituent layers of the present invention coated tools 31 to 40 and the comparative coated tools 31 to 40 was measured using a scanning electron microscope (at a magnification of 5,OOOx). An average layer thickness was obtained by measuring and averaging the layer thicknesses of five points in an observation visual field. All of the results showed substantially the same average layer thicknesses as the target layer thicknesses shown in Tables 18 and 19.

In addition, regarding the hard coating layers of the present invention coated tools 31 to 40 and the comparative coated tools 31 to 40, using the same method as that described in Example 1, the average layer thickness, the average amount Xavg of Al, the average amount Yavg of Me, the average amount Zavg of C, the inclined angle frequency distribution, the difference Δx (= Xmax - Xmin) and period of the periodic concentration variation, the lattice constant a, the average grain width W and average aspect ratio A of crystal grains, and the area ratio of the cubic crystal phase to the crystal grains were obtained.

The results are shown in Tables 18 and 19.

**[Table 17]**

| Type | | Tool body symbol | Lower layer (numerical value at the bottom indicates the average target layer thickness of the layer (µm)) | | | Upper layer (numerical value at the bottom indicates the average target layer thickness of the layer (µm)) |
|---|---|---|---|---|---|---|
| | | | First layer | Second layer | Third layer | First layer |
| Present invention coated tool and comparative coated tool | 31 | a | - | - | - | - |
| | 32 | b | - | - | - | - |
| | 33 | a | - | - | - | - |
| | 34 | b | - | - | - | TiN (0.5) |
| | 35 | a | TiN (0.5) | - | - | - |
| | 36 | b | TiN (0.3) | - | - | - |
| | 37 | a | TiN (0.5) | TiCN (1) | - | - |
| | 38 | b | TiN (0.3) | TiCN (2) | TiN (0.5) | - |
| | 39 | a | - | - | - | TiN (0.5) |
| | 40 | b | - | - | - | - |

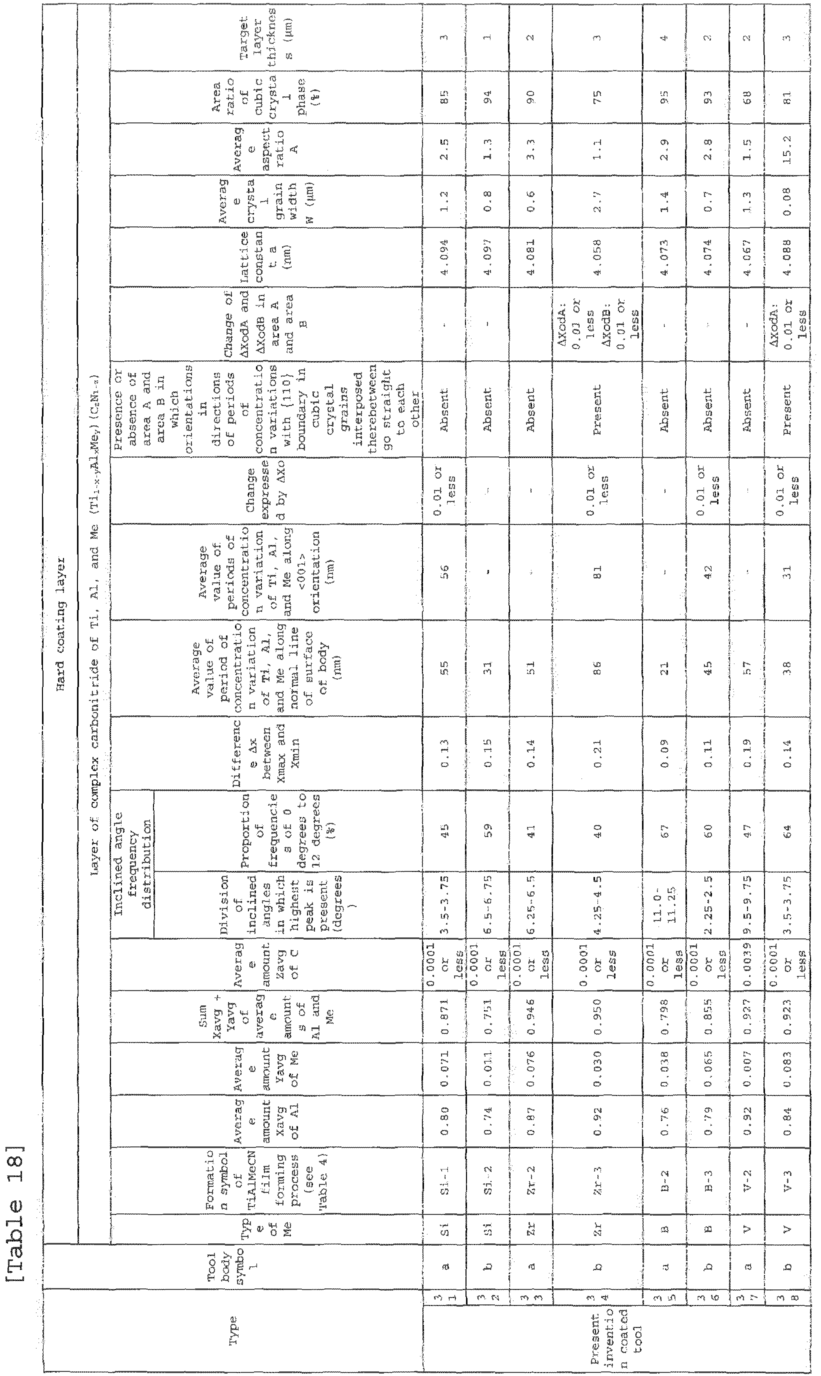

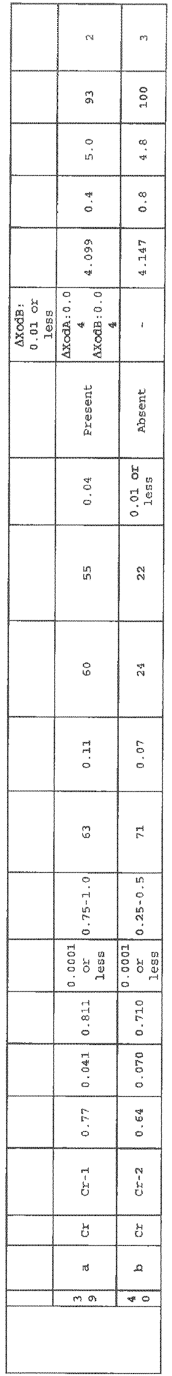

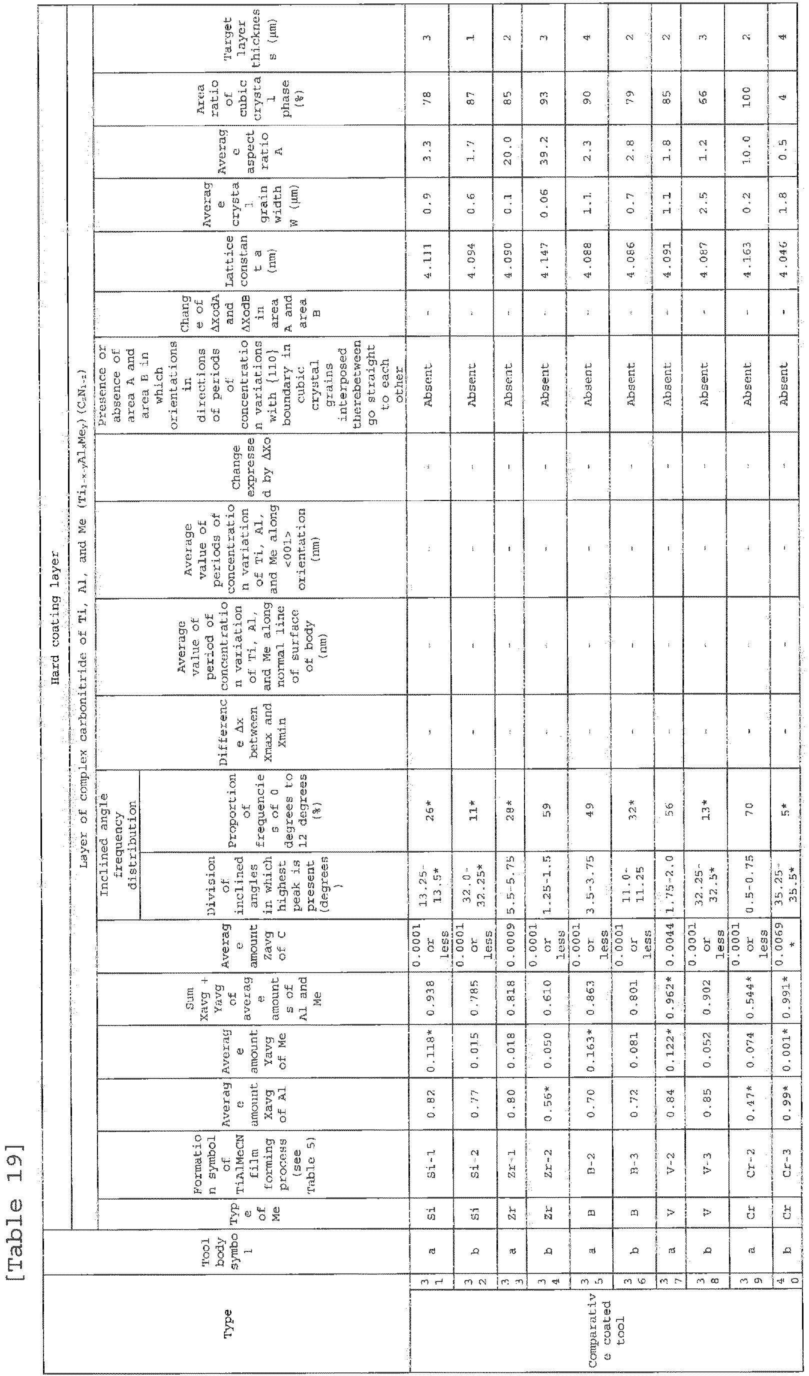

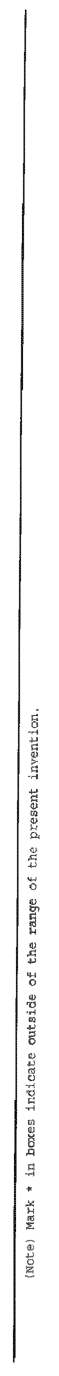

Next, in a state in which each of the various coated tools was screwed to a tip end portion of an insert holder made of tool steel by a fixing tool, the present invention coated tools 31 to 40 and the comparative coated tools 31 to 40 were subjected to a dry high-speed intermittent cutting work test for carburized alloy steel, which will be described below, and the flank wear width of a cutting edge was measured.
Cutting test: dry high-speed intermittent cutting work for carburized alloy steel
Work material: a round bar with four longitudinal grooves formed at equal intervals in the longitudinal direction according to JIS SCr420 (hardness: HRC62)
Cutting speed: 250 m/min
Cutting depth: 0.1 mm
Feed: 0.12 mm/rev
Cutting time: 4 minutes

The results of the cutting test are shown in Table 20.

**[Table 20]**

| Type | | Flank wear width (mm) | Type | | Cutting test results (min) |
|---|---|---|---|---|---|
| Present invention coated tool | 31 | 0.09 | Comparative coated tool | 31 | 2.7* |
| | 32 | 0.14 | | 32 | 2.2* |
| | 33 | 0.13 | | 33 | 3.5* |
| | 34 | 0.07 | | 34 | 3.0* |
| | 35 | 0.13 | | 35 | 2.8* |
| | 36 | 0.08 | | 36 | 3.2* |
| | 37 | 0.11 | | 37 | 3.3* |
| | 38 | 0.07 | | 38 | 2.5* |
| | 39 | 0.10 | | 39 | 2.3* |
| | 40 | 0.09 | | 40 | 2.0* |

| | | | | | |
|---|---|---|---|---|---|
| Mark * in boxes of comparative coated tools and reference coated tools indicates a cutting time (min) until the end of a service life caused by the occurrence of chipping. | | | | | |

From the results shown in Tables 9, 15, and 20, regarding the coated tools of the present invention, in the hard coating layer including at least the cubic crystal grains of the complex nitride or complex carbonitride of Ti, Al, and Me, the cubic crystal grains were aligned with {100} planes and had a columnar structure, and a concentration variation of Ti, Al, and Me was present in the crystal grains. Accordingly, due to the strain in the crystal grains, hardness was improved and toughness was improved while high wear resistance was maintained. Furthermore, it was apparent that even in a case of being used for high-speed intermittent cutting work during which intermittent and impact loads were exerted on a cutting edge, chipping resistance and defect resistance were excellent, and as a result, excellent wear resistance was exhibited during long-term use.

Contrary to this, it was apparent that since the hard coating layer including at least the cubic crystal grains of the complex nitride or complex carbonitride of Ti, Al, and Me included in the hard coating layer did not satisfy requirements specified in the present invention, in a case of being used for high-speed intermittent cutting work during which high-temperature heat is generated and intermittent and impact loads are exerted on a cutting edge, the end of the service life thereof was reached within a short time due to the occurrence of chipping, defects, and the like.

### Industrial Applicability

As described above, the coated tool of the present invention can be used as a coated tool for various work materials as well as for high-speed intermittent cutting work of alloy steel and further exhibits excellent chipping resistance and wear resistance during long-term use, thereby sufficiently satisfying an improvement in performance of a cutting device, power saving and energy saving during cutting work, and a further reduction in costs.

## Claims

1. A surface-coated cutting tool in which a hard coating layer is provided on a surface of a tool body made of any of tungsten carbide-based cemented carbide, titanium carbonitride-based cermet, and a cubic boron nitride-based ultrahigh-pressure sintered body, wherein
(a) the hard coating layer includes at least a layer of a complex nitride or complex carbonitride of Ti, Al, and Me (here, Me is one element selected from among Si, Zr, B, V, and Cr), the layer being formed to an average layer thickness of 1 µm to 20 µm in a chemical vapor deposition method, and in a case where the layer is expressed by the composition formula: (Ti_{1-x-y}AlₓMe_{y}) (C_{z}N_{1-z}), an average amount Xavg of Al of the layer of a complex nitride or complex carbonitride in a total amount of Ti, Al, and Me, an average amount Yavg of Me in the total amount of Ti, Al, and Me, and an average amount Zavg of C in a total amount of C and N (here, each of Xavg, Yavg, and Zavg is in atomic ratio) satisfy 0.60 ≤ Xavg, 0.005 ≤ Yavg ≤ 0.10, 0 ≤ Zavg ≤ 0.005, and 0.605 ≤ Xavg + Yavg ≤ 0.95,
(b) the layer of a complex nitride or complex carbonitride includes at least a phase of a complex nitride or complex carbonitride of Ti, Al, and Me having an NaCl type face-centered cubic structure,
(c) in a case where crystal orientations of crystal grains of the complex nitride or complex carbonitride of Ti, Al, and Me having an NaCl type face-centered cubic structure in the layer of a complex nitride or complex carbonitride are analyzed in a longitudinal sectional direction using an electron backscatter diffraction apparatus, when an inclined angle frequency distribution is obtained by measuring inclined angles of normal lines of {100} planes which are crystal planes of the crystal grains with respect to a normal direction of the surface of the tool body, dividing inclined angles in a range of 0 degrees to 45 degrees with respect to the normal direction among the inclined angles into intervals of 0.25 degrees, and aggregating frequencies present in the respective divisions, a highest peak is present in an inclined angle division in a range of 0 degrees to 12 degrees, and a sum of frequencies that are present in the range of 0 degrees to 12 degrees has a proportion of 35% or more in a total of the frequencies in the inclined angle frequency distribution,
(d) in the crystal grains of the complex nitride or complex carbonitride of Ti, Al, and Me having an NaCl type face-centered cubic structure, a periodic concentration variation of Ti, Al, and Me in the composition formula: (Ti_{1-x-y}AlₓMe_{y}) (C_{z}N_{1-z}) is present, and in a case where an average value of local maximum of values of periodically varying x of an amount x of Al is referred to as Xmax and an average value of local minimum of the values of periodically varying x of the amount x of Al is referred to as Xmin, a difference Δx between Xmax and Xmin is 0.03 to 0.25, and
(e) in the crystal grains having an NaCl type face-centered cubic structure in which the periodic concentration variation of Ti, Al, and Me is present in the layer of a complex nitride or complex carbonitride, a period along the normal direction of the surface of the tool body is 3 nm to 100 nm.

2. The surface-coated cutting tool according to claim 1, wherein
in the crystal grains having an NaCl type face-centered cubic structure in which the periodic concentration variation of Ti, Al, and Me is present in the layer of a complex nitride or complex carbonitride, the periodic concentration variation of Ti, Al, and Me is present along one orientation among equivalent crystal orientations expressed by <001> of the cubic crystal grains, a period along the orientation is 3 nm to 100 nm, and an maximum ΔXo of a change in the amount x of Al in a plane perpendicular to the orientation is 0.01 or less.

3. The surface-coated cutting tool according to claim 1, wherein
in the crystal grains having an NaCl type face-centered cubic structure in which the periodic concentration variation of Ti, Al, and Me is present in the layer of a complex nitride or complex carbonitride,
(a) an area in which the periodic concentration variation of Ti, Al, and Me is present along one orientation among equivalent crystal orientations expressed by <001> of the cubic crystal grains, and when the orientation is referred to as an orientation d_{A}, a period along the orientation d_{A} is 3 nm to 30 nm and an maximum ΔXod_{A} of a change in the amount x of Al in a plane perpendicular to the orientation d_{A} is 0.01 or less is provided, and
(b) an area in which the periodic concentration variation of Ti, Al, and Me is present along one orientation among equivalent crystal orientations expressed by <001> of the cubic crystal grains perpendicular to the orientation d_{A}, and when the orientation is referred to as an orientation d_{B}, a period along the orientation d_{B} is 3 nm to 30 nm and an maximum AXod_{B} of a change in the amount x of Al in a plane perpendicular to the orientation d_{B} is 0.01 or less is provided,
the area A and the area B are present in the crystal grains, and
a boundary between the area A and the area B is formed in one plane among equivalent crystal planes expressed by {110}.

4. The surface-coated cutting tool according to any one of claims 1 to 3, wherein
regarding the layer of a complex nitride or complex carbonitride, lattice constants a of the crystal grains having an NaCl type face-centered cubic structure are obtained from X-ray diffraction, and the lattice constants a of the crystal grains having an NaCl type face-centered cubic structure satisfy a relationship of 0.05a_{TiN} + 0.95a_{AlN} ≤ a ≤ 0.4a_{TiN} + 0.6a_{Aln} for a lattice constant a_{TiN} of cubic TiN and a lattice constant a_{AlN} of cubic AlN.

5. The surface-coated cutting tool according to any one of claims 1 to 4, wherein
regarding the layer of a complex nitride or complex carbonitride, in a case where the layer is observed in the longitudinal sectional direction, a columnar structure in which the crystal grains of the complex nitride or complex carbonitride of Ti, Al, and Me having an NaCl type face-centered cubic structure in the layer have an average grain width W of 0.1 µm to 2.0 µm and an average aspect ratio A of 2 to 10 is included.

6. The surface-coated cutting tool according to any one of claims 1 to 4, wherein
in the layer of a complex nitride or complex carbonitride, an area ratio of the complex nitride or complex carbonitride of Ti, Al, and Me having an NaCl type face-centered cubic structure is 70% by area or more.

7. The surface-coated cutting tool according to any one of claims 1 to 6, wherein
between the tool body made of any of tungsten carbide-based cemented carbide, titanium carbonitride-based cermet, and a cubic boron nitride-based ultrahigh-pressure sintered body, and the layer of a complex nitride or complex carbonitride of Ti, Al, and Me, a lower layer which includes a Ti compound layer that is formed of one layer or two or more layers of a Ti carbide layer, a Ti nitride layer, a Ti carbonitride layer, a Ti oxycarbide layer, and a Ti oxycarbonitride layer and has an average total layer thickness of 0.1 µm to 20 µm is present.

8. The surface-coated cutting tool according to any one of claims 1 to 7, wherein
an upper layer which includes an aluminum oxide layer having an average layer thickness of at least 1 µm to 25 µm is present in an upper portion of the layer of a complex nitride or complex carbonitride.

9. The surface-coated cutting tool according to any one of claims 1 to 8, wherein
the layer of a complex nitride or complex carbonitride is formed by a chemical vapor deposition method in which at least trimethylaluminum is contained as a reaction gas component.
